# FASCICULE DE BREVET EUROPEEN

(11) **EP 4 020 604 B1**
(45) Date de publication et mention de la délivrance du brevet: **30.08.2023**
(21) Numéro de dépôt: 21216425.5
(22) Date de dépôt: 21.12.2021
(51) Int. Cl.: H01L 33/00, H01L 33/16, H01L 27/15, H01L 33/12, H01L 25/16

(54) **PROCÉDÉ DE RÉALISATION D'UN DISPOSITIF OPTOÉLECTRONIQUE COMPRENANT DES MICRO-DIODES ÉLECTROLUMINESCENTES À BASE DE NITRURES DU GROUPE III**
VERFAHREN ZUR HERSTELLUNG EINER OPTOELEKTRONISCHEN VORRICHTUNG UMFASSEND GRUPPE III NITRID-BASIERTEN MIKRO-LEUCHTDIODEN
METHOD FOR MANUFACTURING AN OPTOELECTRONIC DEVICE COMPRISING GROUP III NITRIDE-BASED MICRO LIGHT-EMITTING DIODES

(30) Priorité: 22.12.2020 FR 2013978
(43) Date de publication de la demande: 29.06.2022
(73) Titulaire: Commissariat à l'Energie Atomique et aux Energies Alternatives, 75015 Paris (FR); Centre national de la recherche scientifique, 75016 Paris (FR)
(72) Inventeur: FEUILLET, Guy, 38054 GRENOBLE Cedex 09 (FR); TEMPLIER, François, 38054 GRENOBLE Cedex 0 (FR); ZUNIGA PEREZ, Jesus, 06410 BIOT (FR); VENNEGUES, Philippe, 06600 ANTIBES (FR)
(74) Mandataire: Hautier IP

(56) Documents cités:
- EP-A1- 3 624 192
- WO-A1-2017/194845
- FR-A1- 3 044 464
- US-A1- 2012 276 722

## Description

### DOMAINE TECHNIQUE

La présente invention concerne le domaine des dispositifs optoélectroniques comportant des LEDs (diodes électroluminescentes) à base de nitrure, par exemple de nitrure de gallium (GaN), ainsi qu'un circuit électronique de contrôle de ces LEDs. L'invention trouve pour application particulièrement avantageuse le domaine des dispositifs optoélectroniques dans lesquels les LEDs sont de taille micrométrique. Ces LEDs sont alors souvent désignées par l'expression « micro-LED». Dans ce domaine, une utilisation particulièrement avantageuse de l'invention concerne la réalisation d'écrans de faibles tailles généralement appelées micro-écrans ou encore micro-display. Une autre utilisation avantageuse concerne par exemple la réalisation de projecteurs.

### ETAT DE LA TECHNIQUE

Les micro-LEDs à base de nitrure, en particulier à base de nitrure de gallium (GaN) sont très intéressantes pour les applications de réalité augmentée car elles permettent de fabriquer des microdisplays très compacts et très lumineux. Typiquement la luminance est d'environ 1 MCd/m² ce qui est très supérieur à ce que permettent les technologies OLED (LED organique), dont la luminance ne dépasse pas quelques milliers Cd/m².

Il existe des dispositifs optoélectroniques comportant des LEDs et un circuit électronique permettant de commander individuellement les LEDs pour afficher des images.

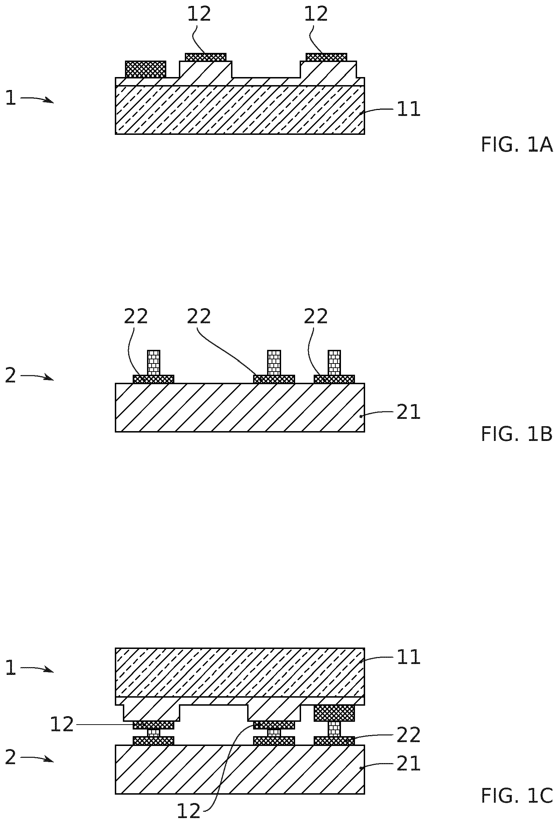

Pour réaliser un tel dispositif, les solutions classiques prévoient de fabriquer séparément le circuit de contrôle et la pluralité de LEDs, puis de les connecter l'un à l'autre pour obtenir le dispositif d'affichage. Cette solution est illustrée en figures 1A à 1C. La figure 1A illustre un empilement 1 comprenant un substrat 11 portant les LEDs 12. Le circuit de contrôle 2 est illustré en figure 1B. Il peut comprendre un substrat semiconducteur 21, par exemple un substrat de silicium. A titre d'exemple, le circuit de contrôle 21 est réalisé en technologie CMOS. Du côté de l'une de ses faces, le circuit de contrôle 2 comprend une pluralité de plots métalliques 22. Chaque plot 22 est destiné à être connecté à une électrode d'une LED 12, pour pouvoir commander les LEDs individuellement.

L'empilement 1 comprenant les LEDs 12 et le circuit de contrôle 2 est couplé par report comme illustré en figure 1C conduisant ainsi à une structure hydride. Cette technique comprend donc le report de ces deux structures 1, 2 ce qui impose de fortes contraintes en termes d'alignement des LEDs 12 et des plots métalliques 22. Le substrat de support 11 portant les LEDs 12 peut ensuite être retiré.

Ainsi, un inconvénient de cette méthode de fabrication réside dans la nécessité d'aligner précisément le circuit de contrôle et l'empilement comprenant les LEDs lors de l'étape d'assemblage de ces deux éléments, de façon que chaque LED vienne bien se positionner sur le plot métallique qui lui correspond dans le circuit de contrôle. Cet alignement est notamment difficile à réaliser lorsque le pas des pixels diminue, et constitue un frein à l'augmentation de la résolution et/ou de la densité d'intégration des pixels. En pratique, avec cette solution le pas des pixels ne peut pas être inférieur à 5 micromètres.

Le document WO 2017/194845 A1, également publié en tant que US 2019/0131343 A1, décrit un procédé de fabrication d'un dispositif optoélectronique comportant une pluralité de LEDs à base de nitrure de gallium.

Avec les solutions connues, il s'avère qu'en pratique les performances électro-optiques des µ-LEDs obtenues sont souvent insatisfaisantes, notamment en termes d'efficacité radiative de luminescence.

Il existe donc un besoin consistant à réduire les inconvénients des solutions connues pour obtenir un dispositif opto-électronique comprenant des micro-LEDs à base de nitrure. En particulier, il serait particulièrement avantageux de proposer une solution pour fabriquer un tel dispositif optoélectronique dont le pas des pixels est faible et/ou dont les pixels présentent des performances électro-optiques améliorées.

### RESUME

Pour atteindre cet objectif, selon un mode de réalisation on prévoit un procédé de réalisation d'un dispositif optoélectronique comprenant des micro-LEDs (diodes électroluminescentes) à base de nitrure, le procédé comprenant les étapes suivantes
a. fournir un assemblage comprenant au moins:
   - un substrat de croissance comportant au moins une couche cristalline, la couche cristalline comprenant une pluralité de rainures parallèles, chaque rainure comprenant au moins deux facettes inclinées opposées formant chacune une bande continue, au moins l'une desdites deux facettes opposées présentant une orientation cristalline {111} ;
   - une structure de nitrure faite au moins en partie d'un nitrure (N) obtenu à partir d'au moins l'un parmi le gallium (Ga), l'indium (In) et l'aluminium (AI), la structure de nitrure comprenant :
      ∘ une couche semi-polaire de nitrure, présentant une première face tournée au regard de la couche cristalline, la couche semi-polaire de nitrure comportant un empilement comprenant au moins des première et deuxième couches semi-conductrices dopées de types de conductivités opposées,
      ∘ des cristallites s'étendant depuis lesdites facettes présentant une orientation cristalline {111} et jusqu'à la première face de la couche semi-polaire de nitrure,
b. fournir un circuit intégré de contrôle présentant une face avant comportant ou électriquement connectée à une pluralité de plots de connexion électrique,
c. rapporter, sur la face avant du circuit de contrôle l'assemblage de sorte que la deuxième couche de l'empilement soit électriquement connectée aux plots de connexion électrique du circuit de contrôle,
d. retirer le substrat de croissance en séparant les cristallites des facettes présentant une orientation cristalline {111},
e. retirer les cristallites,
f. former dans l'empilement des tranchées de sorte à délimiter une pluralité d'îlots destinés chacun à former une micro-LED et connectés chacun à au moins un plot de connexion électrique du circuit de contrôle.

Ainsi, le procédé proposé permet d'obtenir des micro-LEDs, de très petite taille et formées dans une couche semi-polaire de nitrure présentant peu de dislocations. Cela permet d'obtenir des écrans dont le pas est très petit et dont les performances électro-optiques sont considérablement améliorées.

En effet, l'assemblage portant la couche semi-polaire de nitrure, par exemple un substrat SOI, permet de réduire les dislocations dans cette couche, notamment au niveau des joints de grains. En outre, le procédé proposé présente pour avantage que, lors de l'étape de report de la couche de nitrure sur le circuit de contrôle, les positions des différentes LEDs du dispositif ne sont pas encore définies. Il n'y a par conséquent pas de contrainte forte en termes de précision d'alignement lors du report. La délimitation des différentes LEDs dans l'empilement actif peut ensuite être réalisée par des procédés de structuration classiques qui offrent une précision d'alignement nettement supérieure à la précision qui peut être obtenue lors d'un report d'un substrat sur un autre.

En outre, le procédé proposé est particulièrement fiable et peu coûteux.

Par ailleurs, il permet de produire des micro-LEDs de couleurs variées. En particulier, l'utilisation de matériaux dans une orientation semi-polaire permet d'incorporer plus d'indium dans la couche de nitrure. Il est alors possible d'obtenir des LEDs émettant dans la longueur d'onde du vert au rouge et qui offrent une meilleure qualité, notamment en termes de rendement qu'avec les solutions connues. En outre, il est possible d'obtenir des LEDs émettant dans la longueur d'onde du rouge.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les figures 1A à 1C illustrent de manière très schématique un exemple de solution connue pour former un dispositif optoélectronique par report d'un empilement comprenant un ensemble de LEDs sur un circuit de commande.
Les figures 2A à 2I illustrent des étapes d'un exemple de procédé de réalisation d'un dispositif optoélectronique selon l'invention.

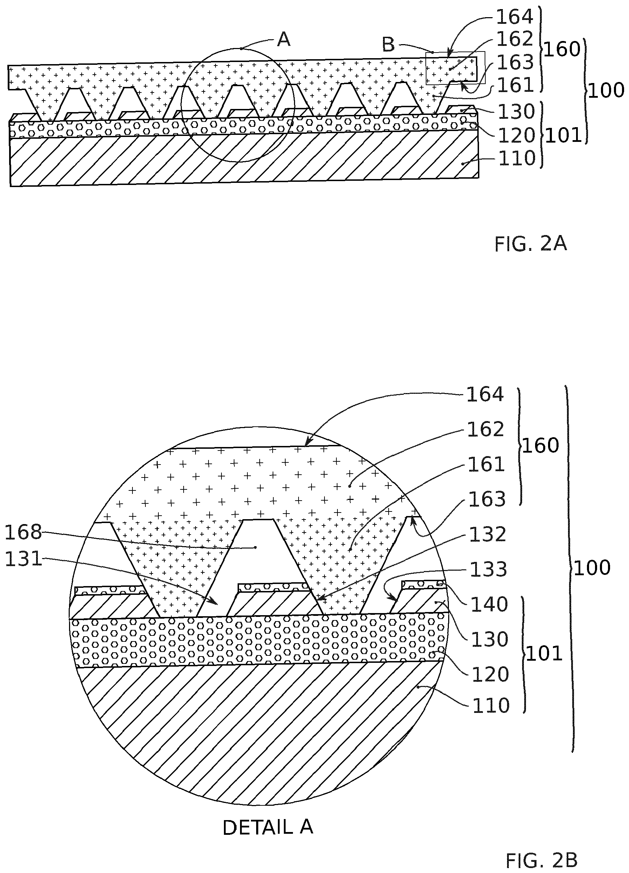

La figure 2A illustre de manière simplifiée un assemblage comprenant un substrat de croissance supportant une structure comportant une couche de nitrure semi-polaire.
La figure 2B montre un agrandissement de la portion A de l'assemblage de la figure 2A.

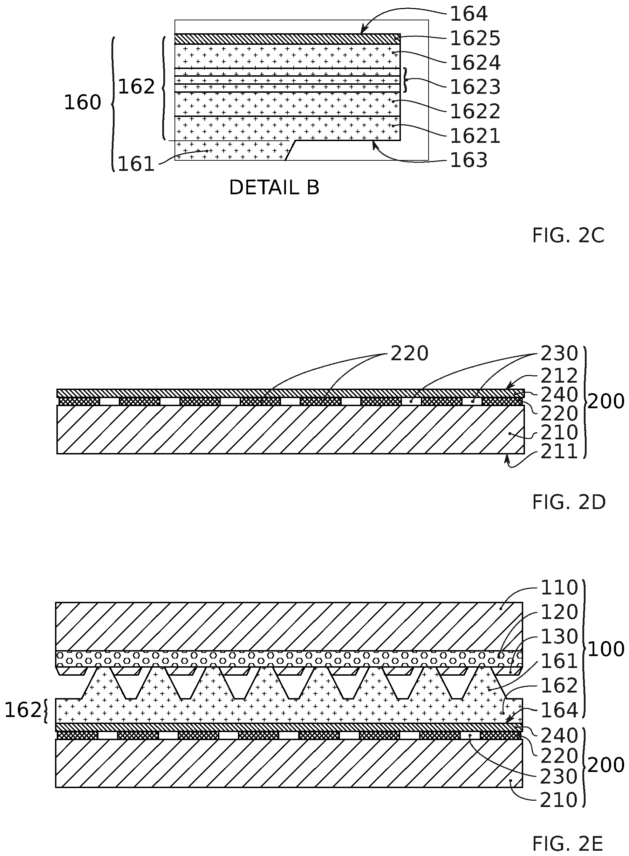

La figure 2C montre un agrandissement de la portion B de la couche de nitrure de la figure 2A pour y montrer les dopages réalisés au sein de cette couche de nitrure semi-polaire afin d'y former des couches de polarité opposées. Sur cette figure, on voit également les empilements de couches formant dans cet exemple non limitatif des puits quantiques.
La figure 2D illustre de manière schématique un circuit de contrôle.
La figure 2E illustre une étape de report de l'assemblage sur le circuit de contrôle.

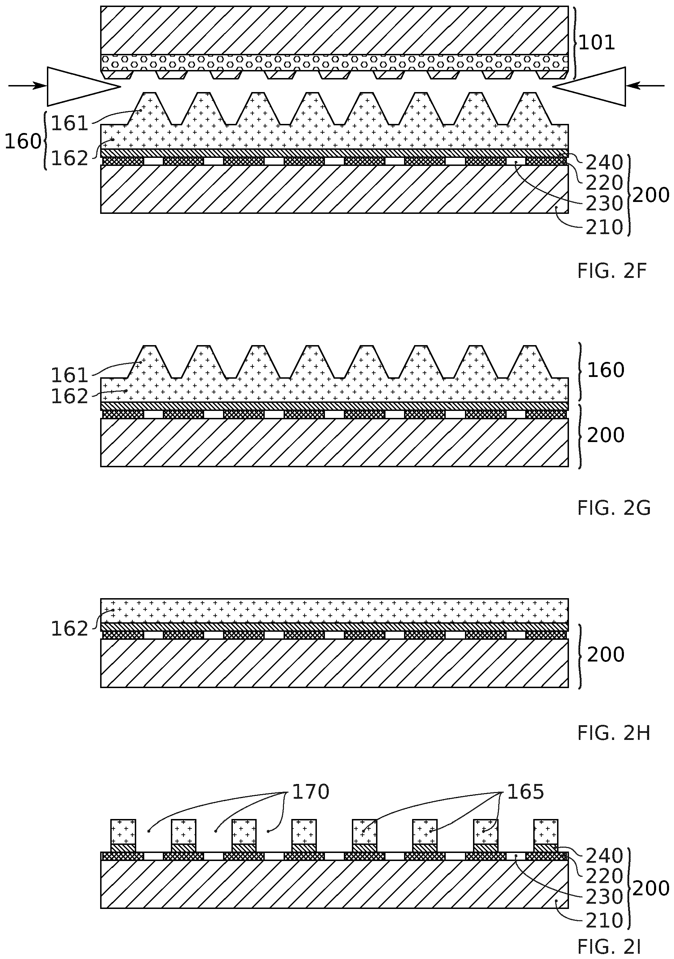

La figure 2F illustre une étape de retrait du substrat de croissance par séparation de ce dernier et de la structure de nitrure, dans un exemple non limitatif de séparation uniquement mécanique.
La figure 2G illustre l'empilement obtenu à l'issue de l'étape de retrait du substrat de croissance.
La figure 2H illustre une étape de planarisation pour retirer les cristallites et pour laisser en place la couche de nitrure.
La figure 2I illustre une étape formation de tranchées à l'intérieur de la couche de nitrure pour délimiter les micro-LEDs au droit de chaque plot de connexion électrique du circuit de contrôle.

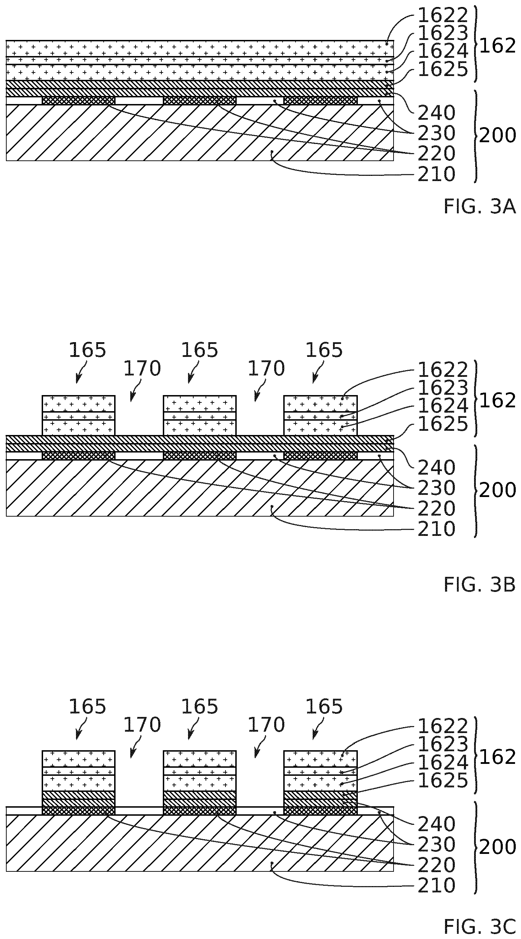

Les figures 3A à 3F illustrent un exemple de procédé de réalisation de LEDs à partir d'une structure initiale comprenant une couche de nitrure reportée sur un circuit de commande, cette structure initiale étant par exemple obtenue en mettant en oeuvre les étapes illustrées en figures 2A à 2H.
La figure 3A illustre de manière schématique un exemple d'assemblage, pouvant par exemple être celui illustré en figure 2A et comprenant une couche de nitrure semi-polaire formée par épitaxie à partir de facette cristallines portées par un substrat de croissance.

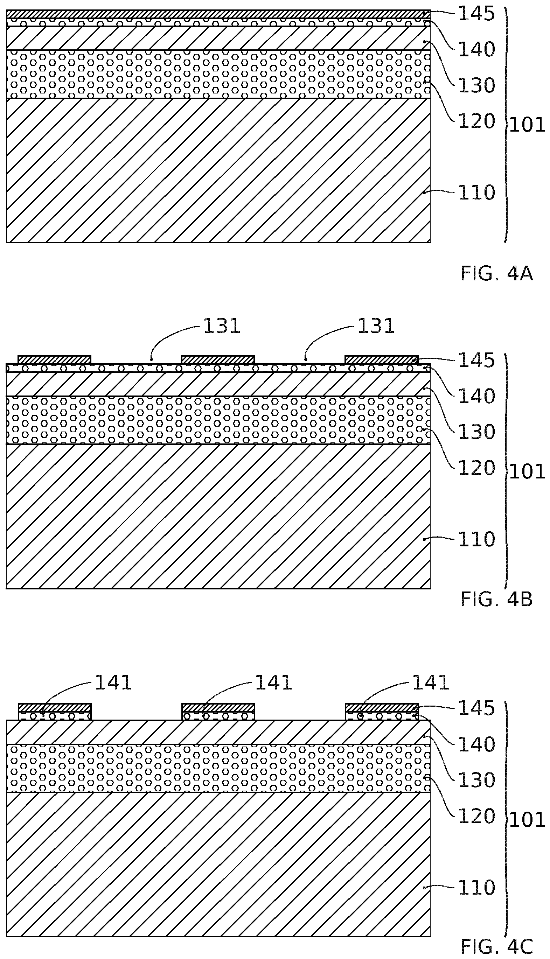

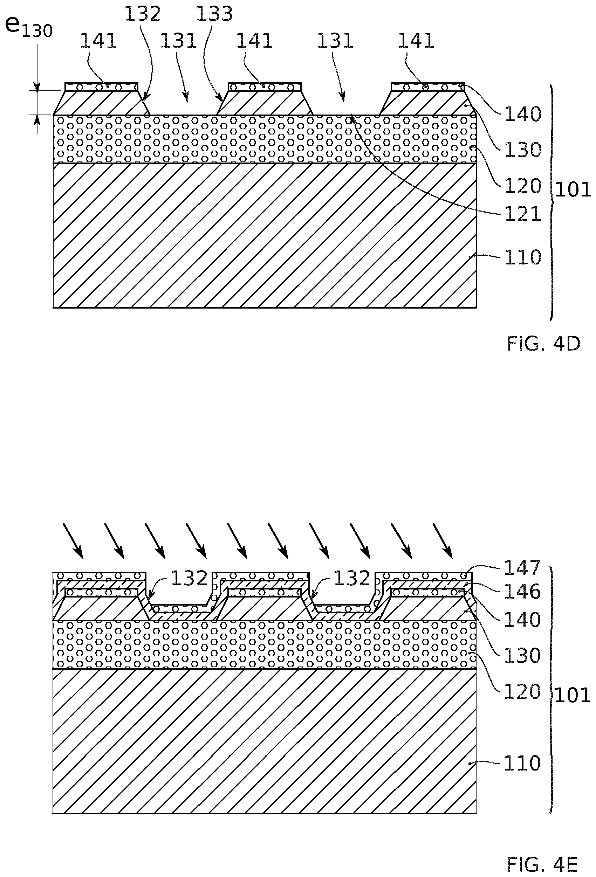

Les figures 4A à 4G illustrent un exemple de procédé de réalisation d'un assemblage comprenant une couche semi-polaire de nitrure. Ce procédé peut être mis en oeuvre pour obtenir l'assemblage illustré en figure 2A.

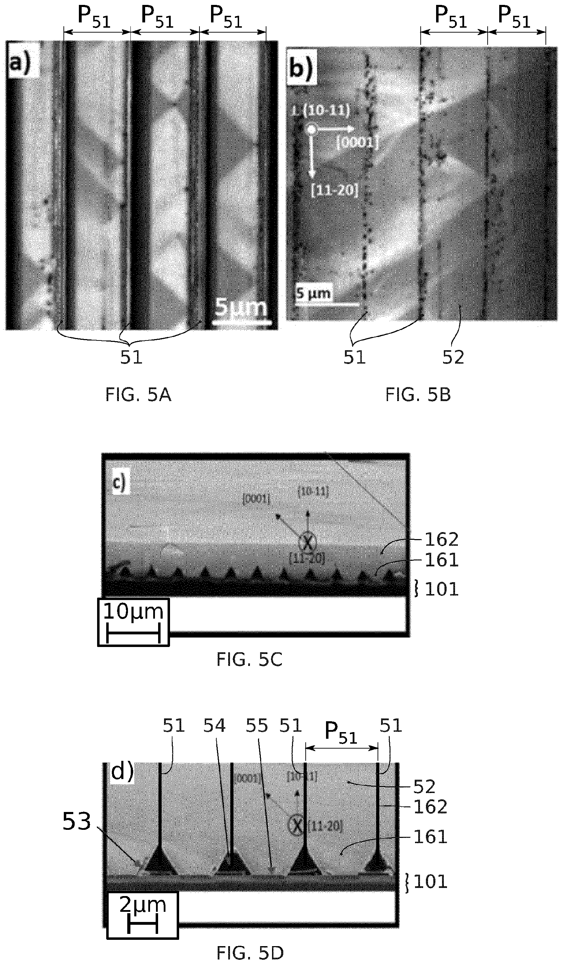

Les figures 5A et 5B sont des images en cathodoluminescence de la répartition des dislocations émergentes pour une couche de GaN semi-polaire.
Les figures 5C et 5D sont des images par microscope électronique à balayage, montrant avec des agrandissements croissants, de coupes d'une couche semi-polaire de nitrure épitaxiée sur un substrat de croissance.

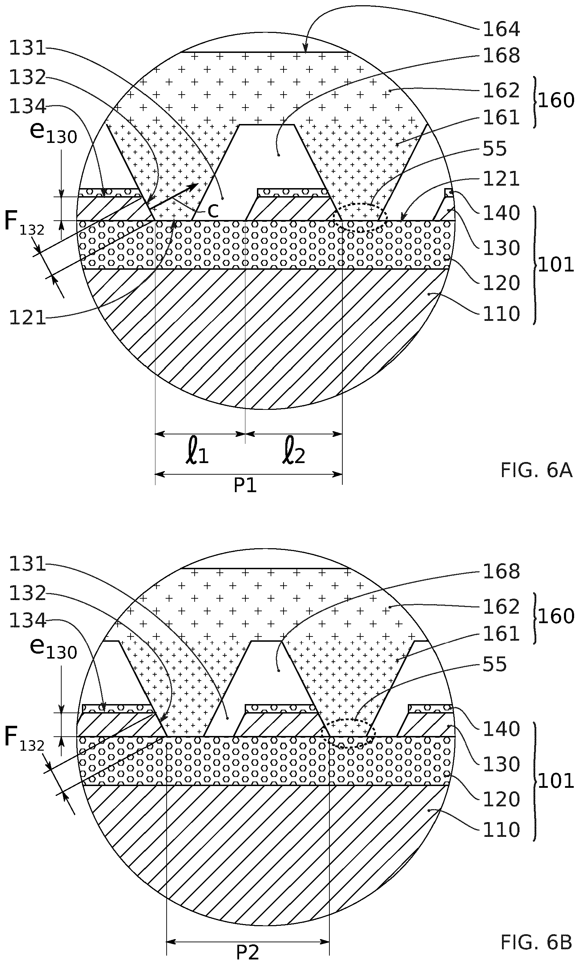

Les figures 6A et 6B sont des illustrations schématiques, reprenant l'illustration de la figure 2B montrant divers paramètres entrant en compte dans le contrôle de l'adhérence entre la structure de nitrure et son substrat de croissance.

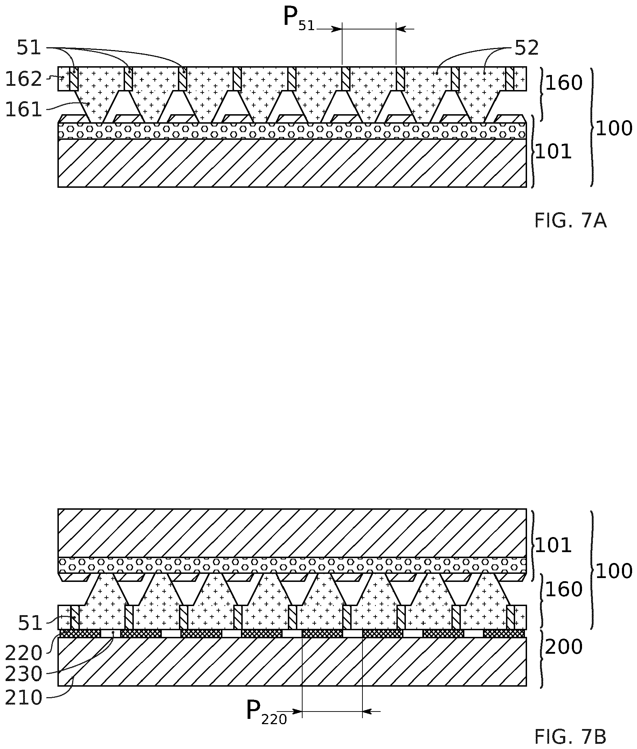

Les figures 7A et 7B illustrent un mode de réalisation particulier, dans lequel l'assemblage et le circuit de contrôle sont alignés en fonction de la répartition des dislocations dans la couche semi-polaire de nitrure.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs des différentes couches, la taille des cristallites, ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, lesdites facettes présentant une orientation cristalline {111} présentent une largeur F132 et les rainures sont disposées de manière périodique selon une période P, le rapport P/F132 étant tel que P/F132≥3, de préférence, P/F132≥5 et de préférence P/F132≥10. Selon un exemple, la largeur F132 est mesurée depuis un sommet des rainures jusqu'à un fond des rainures et selon une direction perpendiculaire à une direction principale d'extension des rainures.

Ce rapport permet que l'adhérence de la structure semi-polaire soit suffisante pour permettre une exécution contrôlée du procédé, notamment lors de la croissance épitaxiale, tout en facilitant la séparation de cette structure semi-polaire par rapport à son substrat de croissance.

Selon un exemple, F132 est mesurée selon une direction commune au plan des facettes orientées <111> et à un plan perpendiculaire à un plan principal dans lequel s'étend une deuxième face de la couche semi-polaire de nitrure opposée à la première face.

Selon un exemple, l'étape d) de retrait du substrat de croissance comprend l'application d'une action mécanique sur au moins l'un parmi le substrat de croissance et la structure semi-polaire de nitrure. Selon un exemple, l'application d'une action mécanique comprend de préférence un amorçage de fracture depuis un bord de l'un parmi le substrat de croissance et la structure semi-polaire de nitrure à l'aide d'un objet contondant.

Selon un exemple, la couche semi-polaire de nitrure comprend une alternance de première zones et de deuxièmes zones formant des bandes ou des lignes parallèles aux rainures, les premières zones présentant des premières densités de dislocations D51 et les deuxièmes zones présentant des deuxième densités D52 de dislocations, avec D51>K1*D52, avec K1>10, de préférence K1>100.

Selon un exemple, D51 correspond à une densité minimale et D52 correspond à une densité maximale.

Selon un exemple, les deuxièmes zones sont réparties de manière périodique dans la couche semi-polaire de nitrure, par exemple sur une deuxième face opposée à la première face, selon une période P51 et les plots de connexion électriques sont distribuées de sorte que la majorité et de préférence que toutes les deuxièmes zones soient respectivement situées au droit d'un seul plot de connexion électrique.

Selon un exemple, on configure la répartition des premières zones de sorte que les premières zones soient retirées par l'étape f) de formation des tranchées.

Ainsi, les LEDs ne comprennent pas les zones de fortes densités de défauts. Les LEDs sont au contraire formées dans les zones présentant des densités de défaut faibles ou nulles. La qualité du dispositif optoélectronique en est encore améliorée.

Selon un exemple, l'épitaxie est une épitaxie en phase vapeur aux organométalliques (MOVPE). Néanmoins, d'autres techniques d'épitaxie sont parfaitement envisageables dans le cadre de la présente invention.

Selon un exemple, les plots de connexion électrique sont séparés les uns des autres par des régions électriquement isolantes, les premières zones étant situées au droit des régions électriquement isolantes.

Selon un exemple, les plots de connexion électrique sont répartis de manière périodique selon une période P220. Selon un exemple, P51= X*P220, avec X compris entre 0,8 et 1,2, de préférence X est compris entre 0,9 et 1,1, de préférence X est compris entre 0,95 et 1,05. Ainsi, de préférence, le pas P220 des plots de connexion électrique et le pas P51 des deuxièmes zones sont identiques. Cela permet d'avoir une connexion précise de chacune des LEDs aux plots tout en réduisant les contraintes de positionnement de l'assemblage sur le circuit de contrôle.

Selon un exemple, l'étape e) de retrait des cristallites comprend une étape de polissage mécanochimique (CMP). Cette étape est simplifiée car on peut stopper le polissage par détection de la zone sans cristallites, qui fait alors office de détection de fin d'attaque. En outre, dans certains cas, l'étape de CMP déclenche le décollement mécanique.

Selon un exemple, la première face est sensiblement plane.

Selon un exemple, le procédé comporte en outre, après l'étape f) de formation des tranchées, une étape de dépôt, sur chaque LED, d'une électrode sur et en contact avec la première face de la couche semi-polaire de nitrure.

Selon un exemple, la couche cristalline est une couche à base de silicium, et le substrat de croissance est un substrat de type semiconducteur sur isolant (SOI) ou un substrat de type silicium sur saphir (SOS).

Selon un exemple, la fourniture de l'assemblage comprend la fourniture du substrat de croissance et une étape de croissance épitaxiale de la structure semi-polaire de nitrure à partir desdites facettes présentant une orientation cristalline {111}.

Selon un exemple, le substrat de croissance comprend une couche d'arrêt sur laquelle la couche cristalline repose en étant directement en contact, la couche d'arrêt étant configurée pour permettre la croissance épitaxiale de la structure semi-polaire de nitrure à partir de la couche cristalline sans croissance épitaxiale à partir de la couche d'arrêt.

Selon un exemple, la couche cristalline est à base de silicium ou est faite de silicium et les facettes sont formées par ou sont recouvertes par une couche tampon cristalline, la couche tampon cristalline est de préférence faite d'AIN.

Selon un exemple, l'étape de croissance épitaxiale comprend : une première croissance épitaxiale d'un matériau à base de nitrure d'aluminium (AIN) à partir desdites facettes présentant une orientation cristalline {111} ; puis au moins une seconde croissance épitaxiale d'un matériau à base de nitrure de gallium (GaN) à partir dudit matériau à base de nitrure d'aluminium (AIN).

Avantageusement, les rainures s'étendent selon une première direction qui correspond à une direction commune au plan de ladite surface supérieure et au plan <111>.

Selon un exemple, on effectue d'abord l'étape e) de retrait des cristallites puis on effectue l'étape f) de formation des tranchées.

Le terme « micro-LED » désigne une LED dont au moins une dimension prise dans un plan parallèle au plan principal dans lequel s'étend le substrat supportant la micro-LED (i.e., le plan xy du repère orthogonal référencé sur les figures) est micrométrique, c'est-à-dire strictement inférieure à 1 mm (10⁻³ mètre) et de préférence comprise entre 0,2 et 100 µm (1 µm = 10⁻⁶ mètre). Dans le cadre de l'invention les micro-LEDs présentent, en projection dans un plan d'extension principal parallèle aux faces principales des micro-LED, i.e., parallèle à une face supérieure du substrat, des dimensions maximales de dimension micrométrique dans le plan. De préférence, ces dimensions maximales sont inférieures à quelques centaines de micromètres. De préférence, ces dimensions maximales sont inférieures à 500 µm.

Dans la suite de la description, les termes cristaux et cristallites seront considérés comme équivalents.

Il est précisé que dans le cadre de la présente invention, les termes « sur », « surmonte », « recouvre » ou « sous-jacent » ou leurs équivalents ne signifient pas « au contact de ». Ainsi par exemple, « le dépôt d'une première couche sur une deuxième couche » ne signifie pas obligatoirement que les deux couches sont directement au contact l'une de l'autre mais cela signifie que la première couche recouvre au moins partiellement la deuxième couche en étant soit directement à son contact, soit en étant séparée d'elle par au moins une autre couche ou au moins un autre élément y compris de l'air.

Les étapes de formation des différentes couches et régions s'entendent au sens large : elles peuvent être réalisées en plusieurs sous-étapes qui ne sont pas forcément strictement successives.

Les termes « sensiblement », « environ », « de l'ordre de » signifient « à 10% près, de préférence 5% près ».

Plusieurs modes de réalisation de l'invention mettant en oeuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer.

Par ailleurs, le terme « étape » s'entend de la réalisation d'une partie du procédé, et peut désigner un ensemble de sous-étapes.

Par ailleurs, le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

Les termes « isolant » ou « diélectrique » qualifient un matériau dont la conductivité électrique est suffisamment faible dans l'application donnée pour servir d'isolant. Dans la présente invention, un matériau diélectrique présente de préférence une constante diélectrique inférieure à 7. Les espaceurs sont typiquement formés en un matériau diélectrique.

Dans le cadre de la présente invention, on qualifie de résine un matériau organique ou organo-minéral pouvant être mis en forme par une exposition à un faisceau d'électrons, de photons ou de rayons X ou mécaniquement. On peut citer à titre d'exemple des résines classiquement employées en microélectronique, des résines à base de polystyrène (PS), de méthacrylate (par exemple le polymethyl méthacrylate PMMA), d'hydrosilsesquioxane (HSQ), de polyhydroxystyrène (PHS) etc. L'intérêt d'utiliser une résine est qu'il est facile d'en déposer une épaisseur importante, de plusieurs centaines de nanomètres à plusieurs microns.

Par dispositif optoélectronique, on entend tout type de dispositif réalisé avec des moyens de la microélectronique et comportant au moins une fonction optique. Il peut aussi s'agir d'un produit intermédiaire uniquement destiné à la réalisation d'un autre dispositif optoélectronique.

### Matériaux

On entend par un substrat, une couche, un dispositif, « à base » d'un matériau M, un substrat, une couche, un dispositif comprenant ce matériau M uniquement ou ce matériau M et éventuellement d'autres matériaux, par exemple des éléments d'alliage, des impuretés ou des éléments dopants.

Ainsi, une « couche à base de nitrure » peut être une couche faite uniquement de ce nitrure ou être faite d'un nitrure additionné d'autres espèces ou de dopants.

Par exemple, une couche ou une structure de nitrure faite au moins en partie d'un nitrure (N) obtenu à partir d'au moins l'un parmi le gallium (Ga), l'indium (In) et l'aluminium (AI), peut être une couche ou une structure à base de GaN, d'InN, d'AIN, d'InGaN, d'AlGaN, d'AllnN.

### Epaisseur et orientation des figures

Il est précisé que dans le cadre de la présente invention, l'épaisseur d'une couche ou du substrat se mesure selon une direction perpendiculaire à la surface selon laquelle cette couche ou ce substrat présente son extension maximale. Sur les figures, l'épaisseur des couches horizontales est prise selon la verticale.

Lorsqu'on indique qu'un élément est situé au droit d'un autre élément, cela signifie que ces deux éléments sont situés tous deux sur une même ligne perpendiculaire au plan principal du substrat, soit sur une même ligne orientée verticalement sur les figures.

Dans la description qui suit, sauf indication contraire, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", "latéral", etc., il est fait référence à l'orientation des figures correspondantes, étant entendu que, dans la pratique, les dispositifs et assemblages décrits peuvent être orientés différemment.

### Dopage

Dans la présente invention des types de dopage seront indiqués. Ces dopages sont des exemples non limitatifs. L'invention couvre tous les modes de réalisation dans lesquels les dopages sont inversés. Ainsi, si un exemple de réalisation mentionne pour une première zone un dopage P et pour une deuxième zone un dopage N, la présente description décrit alors, implicitement au moins, l'exemple inverse dans lequel la première zone présente un dopage N et la deuxième zone un dopage P.

De manière conventionnelle, un dopage noté P+ signifie qu'il s'agit d'un dopage de type P (dopage par des charges positives) et dont la teneur en espèce dopante est supérieure ou égale à 1 atome de l'espèce dopante pour moins de 1000 atomes du semi-conducteur et de préférence pour moins de 10 à 100 atomes du matériau formant la couche semi-conductrice. De même, un dopage N+ signifie qu'il s'agit d'un dopage de type N (dopage par des charges négatives) et dont la teneur en espèce dopante est supérieure ou égale à 1 atome de l'espèce dopante pour moins de 1000 atomes du semi-conducteur et de préférence pour moins de 10 à 100 atomes du matériau formant la couche semi-conductrice.

Dans la présente demande de brevet, un dopage noté P englobe tous les dopages par porteurs de charges positives quelle que soit la teneur du dopage. Ainsi, un dopage P comprend les teneurs en dopage P+ et les teneurs en dopage P inférieures au dopage de type P+. De même, un dopage noté N englobe tous les dopages par porteurs de charges négatives quelle que soit la teneur du dopage. Ainsi, un dopage N comprend les teneurs en dopage N+ et les teneurs en dopage N inférieures au dopage de type N+.

En référence aux figures 2A à 2I un exemple de procédé de réalisation d'un dispositif optoélectronique selon l'invention va maintenant être décrit. Ces étapes seront décrites succinctement avant d'être détaillé par la suite en référence aux autres figures.

La figure 2A illustre de manière simplifiée un assemblage 100 comprenant un substrat de croissance 101 supportant une structure 160 comportant une couche de nitrure semi-polaire 162. La figure 2B illustre un agrandissement de la zone A de cet assemblage 100.

Plus en détail, le substrat de croissance 101 comporte une couche cristalline 130 comprenant une pluralité de rainures 131 ou tranchées parallèles. Elles sont de préférence organisées sous forme d'un réseau, de préférence périodique. Chaque rainure 131 définit au moins deux facettes inclinées 132, 133 opposées formant chacune une bande. Ces bandes sont continues ou discontinues dans le sens de longueur. Au moins l'une 132 des deux facettes 132, 133 opposées présente une orientation cristalline {111}. Ainsi, la couche cristalline 130 est choisie de sorte à présenter, après gravure, des facettes d'orientation {111}.

Sur l'exemple illustré en figure 2A, le substrat de croissance 101 présente une structure de type semi-conducteur sur isolant. Dans ces structures la couche cristalline 130 surmonte une couche d'arrêt 120 (ici une couche isolante) portée par un substrat de support 110. Par exemple le substrat de croissance 101 est un substrat silicium sur isolant SOI (acronyme de l'anglais « silicon on insulator). Selon un mode de réalisation alternatif, le substrat de croissance 101 est de type silicium sur saphir (SOS). Dans ce cas, la couche cristalline 130 est alors une couche à base de silicium surmontant une couche de saphir et séparée de cette dernière par une couche diélectrique habituellement de SiO2. Alternativement, le substrat de croissance 101 peut être massif ou « bulk » selon la terminologie anglo-saxonne.

Dans ces deux modes de réalisation, ces substrats présentent pour intérêt que la couche cristalline 130 présente une épaisseur très petite. Ainsi, la croissance épitaxiale s'effectue à partir d'une surface très restreinte ce qui réduit les dislocations dans la couche épitaxiée. Les performances du dispositif fabriqué à partir de la couche de nitrure sont donc améliorées.

La couche cristalline 130 présente une face supérieure qui dans cette exemple est recouverte par un masque 140 ayant servi, au cours d'une étape préalable non illustrée, à l'ouverture des rainures 131 dans la couche cristalline 130. Le masque 140 est par exemple réalisé par dépôt ou croissance d'une couche d'oxyde de silicium (SiO2) ou de nitrure de silicium (SiN). De manière optionnelle et comme cela sera illustré en figure 4E à 4G, on notera que ce substrat de croissance 101 peut également comprendre un deuxième masque 147 conformé pour masquer les facettes 133 de la couche cristalline 130 qui sont opposés aux facettes 132 présentant l'orientation cristalline {111}.

Un exemple de procédé d'obtention d'un substrat de croissance 101 sera décrit plus en détail en référence aux figures 4A à 4G.

La structure 160 à base de nitrure présente des cristallites 161 qui s'étendent depuis la couche cristalline 130 et jusqu'à la couche semi-polaire 162 de nitrure.

Plus précisément, ces cristallites 161 se sont développées par croissance épitaxiale à partir des facettes 132 présentant l'orientation cristalline {111}. Les cristallites adjacentes sont ensuite entrées en coalescence pour former la couche continue de semi-polaire nitrure 162.

Les avantages de cette technique de croissance de la couche semi-polaire 162 de nitrure seront décrits en détail par la suite. Par ailleurs, un exemple de procédé d'obtention de la structure 160 comportant la couche semi-polaire 162 de nitrure sera décrit plus en détail en référence aux figures 4A à 4G.

À ce stade, on remarquera que la surface de contact entre la structure 160 à base de nitrure et le substrat de croissance 101 est limitée à la surface de contact entre les cristallites 161 et les facettes 132 présentant l'orientation cristalline {111}. Cette surface de contact est faible par rapport à la taille de la couche semi-polaire 162 de nitrure et en particulier à la surface de sa face inférieure 163 tournée au regard du substrat de croissance 101. Ainsi, la surface du substrat de croissance 101 qui retient la couche semi-polaire 162, typiquement une vignette, est très faible devant la surface de cette couche semi-polaire. Comme cela sera décrit plus en détail par la suite, ces facettes 132 de faibles dimensions permettent de réduire la surface à partir de laquelle la croissance épitaxiale est amorcée et donc de limiter le nombre de dislocations générées qui se propagent jusque la surface de la couche semi-polaire 162 épitaxiée.

Dans la suite de la description, la face inférieure 163 est notée première face. On remarque également la présence d'un vide dans l'espace 168 entre la première face 163 de la couche semi-polaire 162 de nitrure et le substrat de croissance 101.

La couche semi-polaire 162 de nitrure est faite au moins en partie d'un nitrure (N) obtenu à partir d'au moins l'un parmi le gallium (Ga), l'indium (In) et l'aluminium (AI). Selon un exemple, elle est à base de nitrure de gallium (GaN) ou est faite de GaN.

La figure 2C montre un agrandissement de la zone B de la couche semi-polaire 162 de nitrure pour y montrer les dopages réalisés au sein de cette couche afin de former des couches de polarité opposées. Cette figure illustre également des empilements de couches formant dans cet exemple des puits quantiques.

La couche semi-polaire 162 de nitrure comprend un empilement de plusieurs couches, de préférence un empilement actif pour former des LEDs. Dans l'exemple représenté, l'empilement actif comprend, dans l'ordre à partir de la première face 163 de la couche semi-polaire 162 de nitrure :
a. une couche tampon 1621 de nitrure. Cet empilement peut ne pas comprendre la couche tampon 1621.
b. une couche 1622 de nitrure dopé d'un premier type parmi un dopage N ou P,
c. une couche émissive 1623,
d. une couche 1624 de nitrure dopé avec un dopage inverse de celui de la couche 1622. Typiquement la couche 1622 de nitrure est dopée N et la couche 1624 de nitrure est dopée P.

L'empilement est par la suite référencé 1622-1624. Il peut comprendre d'autres couches que les couches 1622 à 1624. Par exemple, il peut comprendre la couche tampon 1621 optionnelle et/ou une couche de contact électrique 1625 optionnelle comme cela sera décrit par la suite.

La couche émissive 1623 comprend par exemple ou est constituée par un empilement d'une ou plusieurs couches émissives formant chacune un puits quantique, par exemple à base de GaN, InN, InGaN, AIGaN, AIN, AlInGaN, GaP, AlGaP, AlInGaP, ou d'une combinaison d'un ou plusieurs de ces matériaux. A titre de variante, la couche émissive 1623 peut être une couche de nitrure de gallium intrinsèque, c'est-à-dire non intentionnellement dopée, par exemple de concentration en donneurs résiduels comprise entre 10¹⁵ et 10¹⁸ atomes/cm³, par exemple de l'ordre de 10¹⁷ atomes/cm³. Dans cet exemple, la face inférieure de la couche émissive 1623 est en contact avec la face supérieure de la couche 1622, et la face supérieure de la couche émissive 1623 est en contact avec la face inférieure de la couche 1624.

La figure 2D illustre de manière schématique un circuit de contrôle 200, de préférence il s'agit d'un circuit intégré. Le circuit de contrôle 200 est formé dans et sur un substrat semiconducteur 210, par exemple un substrat en silicium. Dans cet exemple, le circuit de contrôle 200 comprend, du côté de sa face avant 212, pour chacune des LEDs du dispositif, un plot de connexion 220 destiné à être électriquement connecté à la LED, typiquement à l'une des électrodes (anode ou cathode) de cette dernière LED, de façon à pouvoir commander un courant circulant dans la LED et/ou appliquer une tension aux bornes de la LED. De préférence, les plots de connexion 220 sont des plots métalliques.

Le circuit de contrôle comprend par exemple, pour chaque LED, connectée à un plot de connexion 220, une cellule élémentaire de contrôle comportant un ou plusieurs transistors, permettant de contrôler le courant circulant dans la LED et/ou une tension appliquée aux bornes de la LED. Le circuit de contrôle 200 est par exemple réalisé en technologie CMOS. Les plots de connexion 220 peuvent être latéralement entourés par une région 230 faite d'un matériau diélectrique, par exemple de l'oxyde de silicium, de façon que le circuit de contrôle 200 présente une face avant 212 sensiblement plane comprenant une alternance de régions électriquement conductrices et de régions isolantes. Le contact sur les électrodes des LEDs (cathodes ou anodes) non connectées aux plots de connexion 220, peut être pris de façon collective, par exemple dans une région périphérique du circuit de contrôle 200, par l'intermédiaire d'un ou plusieurs plots de connexion (non visibles sur la figure) du circuit de contrôle 200.

La figure 2E illustre une étape au cours de laquelle l'assemblage 100 comportant la couche semi-polaire 162 de nitrure est rapporté sur le circuit de contrôle 200. Plus précisément, la face supérieure 164 de la couche semi-polaire 160 nitrure, également désigné deuxième face, est rapportée sur la face avant 212 du circuit de contrôle 200. Pour cela, l'assemblage 100 peut être retourné, puis rapporté sur le circuit de contrôle 200, de façon à mettre en contact la deuxième face 164 de l'assemblage 100 en contact avec la face avant 212 du circuit de contrôle 200. Au cours de cette étape, l'empilement actif 1622-1624 de la couche semi-polaire 160 de nitrure est fixé (bonded) au circuit de contrôle 200.

A titre d'exemple, la fixation de la couche de nitrure 162 comprenant l'empilement actif 1622-1624 sur le circuit de contrôle 200 peut être obtenue par collage moléculaire direct entre les deux surfaces mises en contact. A titre de variante, la fixation des deux surfaces peut être réalisée par thermocompression, collage eutectique, ou par toute autre méthode de fixation adaptée.

De manière optionnelle mais préférée, pour faciliter ce collage et permettre une bonne conductivité électrique entre la couche de nitrure 162 et les plots de connexion 220, on prévoit de former sur au moins l'une des faces 164, 212 destinées à être en contact, une couche électriquement conductrice.

De préférence, avant l'étape de report on prévoit :
a. un dépôt sur l'empilement actif 1622-1624 de LEDs, d'au moins une couche conductrice 1625. Cette couche conductrice 1625 forme alors la deuxième face 164 de la couche semi-polaire 162 de nitrure. Cette couche conductrice 1625 est représentée en figure 2C. Cette couche 1625 n'est pas représentée sur les figures 2E à 2I pour les raisons de simplification des figures et également puisque cette couche 1625 n'est qu'optionnelle. De préférence, cette couche revêt par exemple sensiblement toute la surface de l'empilement actif 1622-1624. De préférence, pour assurer un bon contact ohmique, on dépose une couche d'aluminium (AI) ou de ITO (oxyde d'indium étain). De manière alternative ou additionnelle, on peut déposer également une couche métallique, par exemple en titane (Ti) pour assurer un bon contact. Selon un exemple on effectue ensuite un recuit de l'assemblage.
b. un dépôt sur la face avant 212 du circuit de contrôle 200, d'une couche destinée à assurer un bon collage et une bonne conduction électrique. De préférence cette couche est métallique. Elle est référencée 240. De préférence, la couche métallique revêt sensiblement toute la surface avant 212 du circuit de contrôle 200. En particulier, la couche métallique est en contact avec les plots de connexion 220. Cette couche 240 surmonte les plots de connexion 220 et les régions isolantes 230. La face supérieure de cette couche 240 forme alors la face avant 212 du circuit de contrôle 200.

La figure 2F illustre une étape postérieure à l'étape de report de la figure 2E, au cours de laquelle le substrat de croissance 101 de l'assemblage 100 est retiré de façon à laisser sur le circuit de commande 200 la structure semi-polaire 160 de nitrure comportant les cristallites 161 et la couche semi-polaire 162 de nitrure.

De préférence, le retrait du substrat de croissance 101 est obtenu en exerçant une action mécanique. Par exemple, on peut exercer une action qui génère un effort de cisaillement entre le substrat de croissance 101 et la structure semi-polaire 160 de nitrure. Comme indiqué précédemment en référence aux figures 2A et 2B, la surface de contact entre le substrat de croissance 101 et la structure semi-polaire 160 de nitrure est faible puisque limitée à la surface de contact entre les cristallites 161 et les facettes 132 présentant l'orientation cristalline {111}. Cette séparation s'effectue donc de manière parfaitement contrôlée. Ce procédé offre donc une solution particulièrement efficace pour reporter de manière peu coûteuse et reproductible une couche semi-polaire de nitrure sur un circuit de commande.

Par exemple, on peut amorcer la fracture par l'un des bords de la plaque formant l'assemblage 100, par exemple à l'aide d'un outil contondant. On peut utiliser de nombreux procédés pour amorcer ou effectuer complètement cette facture. On peut par exemple utiliser les outils qui permettront un cisaillement. On peut également utiliser des ultrasons.

La figure 2G illustre l'empilement obtenu à l'issue de l'étape de retrait du substrat de croissance 101.

La figure 2H illustre le résultat obtenu après une étape de retrait des cristallites 161. Cette étape laisse en place la couche semi-polaire 162 de nitrure. De préférence, cette étape comprend une planarisation, par exemple par polissage mécanochimique (CMP). Le retrait des cristallites 161 peut également être effectué par voie chimique. Pour cela, on peut recourir aux gravures classiques de silicium, par exemple à base d'une solution d'hydroxyde de potassium (KOH).

La figure 2I illustre une étape de formation de tranchées 170 à l'intérieur de la couche semi-polaire 162 de nitrure pour délimiter des îlots 165 ou mesas formant ou destinés chacun à former une micro-LED. Dans la suite de la description, la référence 165 sera utilisée aussi bien pour désigner une LED que pour désigner un îlot formant ou destiné à former une LED. De préférence, les tranchées forment deux réseaux qui se croisent, de préférence à 90°, pour définir les îlots. Ainsi, dans cet exemple un îlot est défini entre quatre tranchées parallèles deux à deux. Chaque LED ou îlot formé dans l'empilement 1622-1624 est entouré latéralement par une tranchée 170. Ces tranchées 170 sont par exemple formées par gravure à partir de la deuxième face 164 de la couche semi-polaire 162 de nitrure. Chaque îlot 165 et situé au droit d'un plot 220 de connexion électrique du circuit de contrôle 200. Ces îlots 165 sont par exemple formés par lithographie et gravure, ce qui offre, avec les techniques classiques de la micro-électronique une précision de positionnement très élevée.

En outre, il est possible de réaliser un dispositif sur des substrats de grandes dimensions. L'assemblage 100 et le circuit de commande 200 peuvent être respectivement formés sur des plaques de grandes dimensions. Ces plaques peuvent par exemple présenter un diamètre ou une diagonale de 200 voire de 300 millimètres. Elles présentent les tailles classiques des plaques (wafer) habituellement utilisées pour les technologies CMOS.

Par ailleurs, il ressort clairement de la description qui précède que la séparation du substrat de croissance et de la couche semi-polaire de nitrure est obtenue de manière simple et parfaitement contrôlée. Dans les solutions classiques, par exemple celle illustrée en figure 1A à 1C, le retrait d'un substrat de support en silicium nécessite une étape de meulage (grinding) qui est longue et génère d'importantes pertes de matières. Par ailleurs, le procédé proposé permet de détecter très aisément à quel instant l'étape de meulage doit être stoppée. Par ailleurs, le retrait d'un substrat de support en saphir nécessite une étape de détachement de type lift-off, ce qui augmente significativement le coût de la fabrication.

Avec les solutions connues, les couches semi-polaires de nitrure utilisées pour former les LEDs présentent des performances (en termes d'efficacité radiative de luminescence par exemple) bien plus faibles dans la gamme de longueur d'onde du bleu. Dans la gamme de longueur d'onde du vert ces performances sont habituellement bien plus faibles. Dans la gamme de longueur d'onde du rouge les procédés classiques ne permettent pas d'atteindre des performances acceptables. Au contraire, la couche semi-polaire de nitrure formant la micro LED du dispositif optoélectronique obtenu avec le procédé selon l'invention présente très peu de défauts, en particulier peu de dislocations au niveau des joints de coalescence entre cristallites. Ces joints de coalescence correspondent aux zones 51 référencées à la figure 7A qui sera décrite en détail par la suite.

Ainsi, le procédé présenté ci-dessus présente pour avantage de permettre l'obtention de micro LEDs de très petite taille et formées à partir d'une couche semi-polaire de nitrure présentant une très haute qualité. L'écran obtenu peut ainsi présenter un très petit pas de pixel. En outre, les micro-LEDs peuvent émettre dans les longueurs d'onde du rouge et du vert avec une qualité améliorée.

Les figures 3A à 3F illustrent un exemple plus détaillé de procédé de réalisation de dispositifs optoélectroniques à partir de l'assemblage du circuit de commande 200 et de la couche semi-polaire 162 de nitrure.

Comme illustré en figure 3A, la première étape de ce procédé consiste à fournir un assemblage illustré en figure 2H et comprenant la couche semi-polaire 162 de nitrure reporté sur le circuit de commande 200. Ainsi, sur cette figure, on retrouve les couches suivantes empilées depuis la face avant du circuit de commande 100, cette face avant étant typiquement formée par la face de la couche métallique 240: la couche métallique 1625, la couche 1624 de nitrure dopé avec un premier dopage (typiquement un dopage de type P), la couche émissive 1623 comprenant les multiples puits quantiques, la couche 1622 de nitrure dopé avec un deuxième dopage (typiquement un dopage de type N).

On remarquera que sur cette figure l'empilement 1622-1624 n'illustre pas la couche tampon 1621 de nitrure. Cette couche tampon 1621 peut en effet avoir été enlevée lors du retrait des cristallites 161 ou lors d'une étape ultérieure à ce retrait. Pour retirer cette couche tampon 1621 on peut la graver par plasma. L'arrêt de cette gravure peut être déclenchée pour la détection de la mise à nue de la couche 1622 (dopée N par exemple).

La figure 3B illustre l'étape de gravure des tranchées 170 dans l'empilement actif 1622-1624, depuis sa face supérieure 166, par exemple par lithographie puis gravure, de façon à délimiter la pluralité de LEDs 165.

Chaque LED 165 correspond à un îlot formé dans l'empilement 162 et entouré latéralement par une tranchée 170. L'îlot peut présenter un pourtour circulaire ou de toute autre forme, par exemple polygonale (carré ou rectangle par exemple). Les tranchées 170 s'étendent verticalement sur toute la hauteur de l'empilement 162. Ainsi, chaque LED 165 comprend un empilement vertical comportant, dans l'ordre à partir de la face supérieure de la couche métallique 1625, une portion de la couche de nitrure 1624, correspondant à l'anode de la LED dans cet exemple, une portion de la couche émissive 1623, et une portion de la couche de nitrure 1622, correspondant à la cathode de la LED dans cet exemple. Les tranchées 170 peuvent être alignées sur des repères préalablement formés sur le circuit de contrôle 200. Dans l'exemple non limitatif représenté, chaque LED 165 est située, en projection verticale, en regard d'un unique plot de connexion 220 du circuit de contrôle 200. Dans cet exemple, les tranchées 170 sont situées, en projection verticale, en regard des régions isolantes 230 de la face supérieure du circuit de contrôle 200. Dans l'exemple représenté, la couche métallique 240 sert de couche d'arrêt de gravure lors de la réalisation des tranchées 170 dans l'empilement actif 1622-1624.

La figure 3C illustre une étape ultérieure de retrait, par exemple par gravure, des portions des couches métalliques 1625 et 240 situées au fond des tranchées 170, de façon à prolonger les tranchées 170 jusqu'aux régions isolantes 230 de la face supérieure du circuit de contrôle 200. A l'issue de cette étape, les anodes (régions 1625) des différentes LEDs 165 sont isolées électriquement les unes des autres par les tranchées 170, et chaque LED 165 a son anode connectée au plot métallique 220 sous-jacent par l'intermédiaire des portions de couches métalliques 1625 et 240 subsistant entre la LED et le plot 220. Ceci permet un contrôle individuel des LEDs par le circuit de contrôle 200.

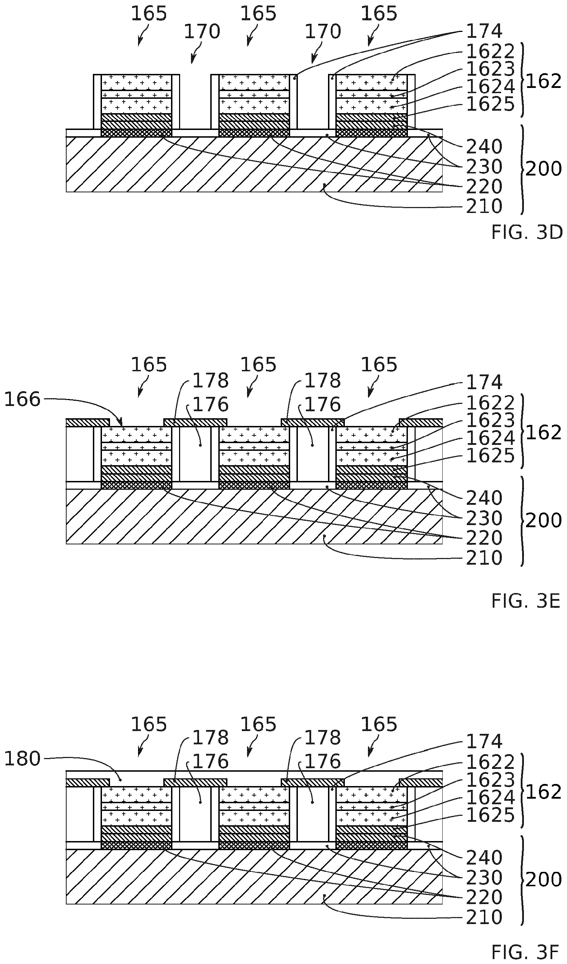

La figure 3D illustre une étape ultérieure de dépôt, sur les flancs des LEDs 165, d'une couche isolante de passivation 174, par exemple en oxyde de silicium. La couche 174 est par exemple déposée sur toute la surface supérieure de l'assemblage par une technique de dépôt conforme, puis retirée uniquement sur la face supérieure des LEDs 165 et au fond des tranchées 170, par exemple par gravure anisotrope.

La figure 3E illustre une étape postérieure à l'étape de la figure 3D, au cours de laquelle les tranchées 170 sont comblées par un matériau isolant 176, par exemple de l'oxyde de silicium. A titre d'exemple, une couche d'oxyde de silicium suffisamment épaisse pour combler les tranchées 170 est déposée sur toute la surface supérieure de l'assemblage, puis une étape de planarisation, par exemple un polissage mécanochimique (CMP), est mise en oeuvre pour retirer l'oxyde de silicium sur la surface supérieure des LEDs 165. A l'issue de cette étape, la face supérieure 166 du dispositif est sensiblement plane et comprend une alternance de régions isolantes 174, 176 et de régions de nitrure 1622. En variante, l'étape de remplissage des tranchées 170 (figure 3E) et l'étape de passivation des flancs des LEDs (figure 3D) peuvent être combinées.

La figure 3E illustre également une étape postérieure au remplissage des tranchées 170 par le matériau isolant 176, au cours de laquelle une ou plusieurs métallisations 178 sont formées sur la face supérieure 166 du dispositif, en contact avec les régions de cathode 1622 des LEDs 165. Dans cet exemple, les régions de cathode des LEDs 165 sont toutes connectées à une même métallisation 178. La métallisation 178 vient contacter, sur chacune des LEDs 165, une partie périphérique de la face supérieure de la région de cathode 1622 de la LED. Au niveau de chacune des LEDs 165, une partie centrale de la LED n'est en revanche pas recouverte par la grille métallique 178, de façon à permettre le passage de la lumière émise par la LED. En effet, dans l'exemple représenté, le dispositif d'affichage est destiné à être observé du côté de sa face supérieure 166. La grille métallique 178 peut être connectée au circuit de contrôle 200, par exemple par l'intermédiaire d'un ou plusieurs vias (non représentés) formés dans l'empilement actif 1622-1624 ou dans le matériau isolant 176 de remplissage des tranchées 170, par exemple dans une région périphérique du dispositif.

La figure 3F illustre une étape postérieure au dépôt des métallisations 178, au cours de laquelle une couche isolante 180, par exemple en oxyde de silicium, est déposée sur sensiblement toute la surface supérieure du dispositif, pour protéger les métallisations 178 et les portions apparentes de la couche de nitrure de gallium 162. La couche isolante 180 peut être planarisée de façon à obtenir un dispositif d'affichage présentant une surface supérieure sensiblement plane.

Dans l'exemple de réalisation décrit en relation avec les figures précédentes, le dépôt des couches métalliques 1625 et 240 sur le circuit de contrôle 200 et sur l'empilement actif 1622-1624 préalablement au report de l'empilement actif 1622-1624 sur le circuit de contrôle 200 présente plusieurs avantages.

En particulier, les couches 1625 et 240 permettent d'améliorer la qualité du collage entre les deux structures. En effet, bien que possible, le collage direct de la face supérieure (dans l'orientation de la figure 1A) de la couche de nitrure 1624 sur la surface avant 212 du circuit de contrôle 200 (comprenant une alternance de régions isolantes 230 et de régions métalliques 220) est relativement délicat à réaliser.

En outre, la couche 1625 peut avantageusement être choisie pour réaliser un bon contact ohmique avec la couche de nitrure 1624. Le matériau des plots métalliques 220 du circuit de contrôle 200, par exemple du cuivre ou de l'aluminium, peut en effet ne pas être adapté à la réalisation d'un tel contact ohmique.

De plus, les couches 240 et/ou 1625 peuvent comprendre un métal réfléchissant pour la lumière émise par les LEDs 165, de façon à augmenter l'efficacité d'émission et éviter des déperditions de lumière dans le circuit de contrôle 200.

Par ailleurs, la couche 240 et/ou la couche 1625 peuvent être choisies de façon à éviter que du métal des plots de connexion 220 du circuit de contrôle 200, par exemple du cuivre, ne diffuse vers la couche de nitrure de gallium 1624, ce qui pourrait notamment dégrader la qualité du contact ohmique avec la couche de nitrure de gallium 1624.

En pratique, chacune des couches 240 et 1625 peut être une couche unique ou un empilement d'une ou plusieurs couches de métaux différents permettant d'assurer tout ou partie des fonctions susmentionnées.

A titre d'exemple la couche 240 comprend une couche supérieure en un métal de même nature que la couche supérieure 1625, ce métal étant choisi pour obtenir un bon collage entre les deux structures lors de l'étape de report illustrée en figure 2E, par exemple un métal du groupe comprenant le Ti, le Ni, le Pt, le Sn, l'Au, l'Ag, l'AI, le Pd, le W, le Pb, le Cu, l'AuSn, le TiSn, le NiSn ou un alliage de tout ou partie de ces matériaux. L'empilement formé par les couches 240 et 1625 peut en outre comprendre une ou plusieurs couches en des métaux adaptés à réfléchir la lumière émise par les LEDs, par exemple de l'argent. De plus, l'empilement formé par les couches 240 et 1625 peut comprendre une ou plusieurs couches adaptées à faire barrière à la diffusion de métaux tels que le cuivre ou l'argent compris dans l'empilement 240/1625 et/ou dans les plots métalliques 220, par exemple des couches de TaN, TiN, WN, TiW, ou d'une combinaison de tout ou partie de ces matériaux.

En variante, la couche 240 et/ou la couche 1625 peuvent toutefois être absente(s). De préférence, au moins l'une des couches 240 et 1625 est prévue, de préférence la couche 1625 formée du côté de l'empilement actif 1622-1624 de LEDs.

Un exemple d'obtention d'un assemblage 100 identique ou proche de celui illustré en figure 2A va maintenant être décrit en référence aux figures 4A à 4G. Cet assemblage 100 comprend le substrat de croissance 101 surmonté d'une structure semi-polaire 160 de nitrure.

Dans un premier temps, en référence aux figures 4A à 4E un exemple non limitatif de procédé permettant l'obtention du substrat de croissance 101 sera décrit en détail.

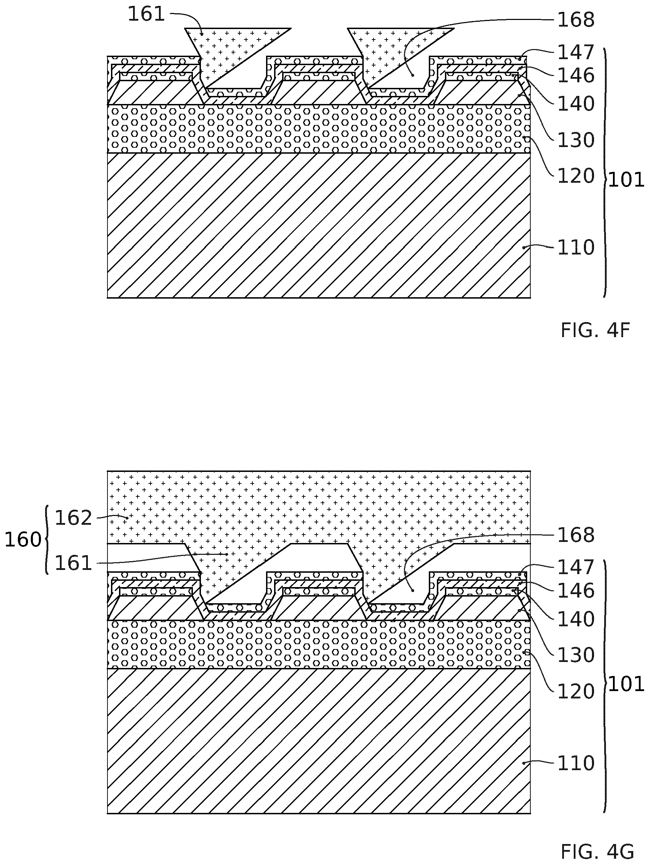

Dans un second temps, en référence aux figures 4F à 4G un exemple non limitatif de procédé permettant la croissance de la structure semi-polaire 160 de nitrure à partir du substrat de croissance 101 sera décrit en détail.

### Réalisation du substrat de croissance 101

Une étape, illustré en figure 4A comprend la fourniture d'un empilement comportant successivement depuis un substrat de support 110 : une couche d'arrêt 120, une couche cristalline 130, une première couche de masquage 140 et une deuxième couche de masquage 145.

Par exemple, le substrat de support 110 est en silicium. La couche d'arrêt 120 est une couche de SiO2 et la couche cristalline 130 est une couche de silicium. L'empilement 110, 120, 130 forme de préférence un substrat élaboré de type silicium sur isolant (SOI), dans lequel la couche 130 constitue la couche habituellement désignée top Si. Comme déjà indiqué ci-dessus, cet empilement peut également être de type silicium sur saphir, dans lequel la couche cristalline 130 est une couche de silicium.

L'orientation de la couche cristalline superficielle 130 du substrat, typiquement en silicium, présente un décalage d'orientation du plan cristallin (001) de 7° vers [110] de façon à obtenir ensuite une couche épitaxiale de GaN d'orientation (10-11)

La première couche de masquage 140 est un masque dur, par exemple fait de SiO2 ou de nitrure de silicium (SiN). Ce masque dur 140 présente par exemple une épaisseur de 50 nanomètres. Ce masque dur 140 est recouvert d'une deuxième couche de masquage 145 typiquement faite ou à base de résine.

Comme illustré sur les figures 4B à 4D, on grave ensuite des rainures 131 dans la couche cristalline 130. Ces rainures 131 sont des motifs en creux, et forment ainsi des tranchées.

Pour cela on réalise des bandes parallèles 141 dans la couche de masquage 140. Cette structuration de la couche de masquage 140 s'effectue de manière classique par lithographie et gravure à travers la couche 145 formant un masque de résine. L'étape de structuration du masque de résine 145 et l'étape de gravure de la couche de masquage 140 pour former le masque dur sont illustrées en figure 4B et 4C. Le masque dur forme ainsi des bandes parallèles 141 recouvrant la couche cristalline 130 et laissant à découvert d'autres bandes parallèles de cette couche cristalline 130.

Les bandes parallèles 141 sont orientées dans une direction cristalline prédéterminée de la couche cristalline 130. La couche cristalline 130 présente une face interne en regard d'une face supérieure 121 de la couche d'arrêt 120 et une face externe opposée à la face interne, ladite face externe étant également désignée surface supérieure. La direction d'orientation des bandes parallèles 141 doit correspondre à une direction commune au plan de la face externe de la couche cristalline 130 et au plan <111> que l'on veut révéler par attaque chimique. Cette direction est une direction de type <110>. Ainsi les bandes 141 sont parallèles à l'intersection entre le plan de la surface supérieure de la couche cristalline 130 et le plan <111>.

Afin de révéler les facettes 132 d'orientation {111}, la couche cristalline 130 est ensuite gravée chimiquement, en utilisant par exemple du KOH (hydroxyde de potassium) ou encore du tétra-méthyl ammonium hydroxyde (TMAH).

Les rainures 131 ainsi formées par gravure sont parallèles aux bandes 141. Ainsi ces rainures 131 définissent des rainures parallèles orientées selon la direction commune au plan de la face externe de la couche cristalline 130 et au plan <111>.

Sur l'exemple non limitatif illustré sur les figures 4A à 4G, la gravure s'arrête automatiquement lorsque la couche d'arrêt 120 est atteinte. Ainsi la gravure s'arrête avant que les facettes 132 d'orientation {111} se rejoignent comme cela serait le cas en l'absence de couche d'arrêt, c'est-à-dire en utilisant un substrat cristallin massif.

Ainsi, plutôt que de fixer la hauteur des facettes 132 d'orientation {111} par le temps d'attaque, celle-ci est complètement déterminée, avec le procédé de l'invention, par l'épaisseur e130 de la couche cristalline 130 de silicium du substrat SOI.

Le fait de contrôler avec précision la profondeur des rainures 131 et d'obtenir des tranchées de faibles épaisseurs permet de diminuer fortement la surface à partir de laquelle les cristallites 161 vont se former. Cela permet de réduire considérablement le nombre de dislocations générées qui se propagent jusqu'à la surface de la couche semi-polaire. La couche semi-polaire 162 formée après coalescence des cristallites présente alors un nombre de dislocations fortement diminué. Les LEDs formées dans cette couche présentent alors des performances significativement améliorées.

Par ailleurs, le phénomène de melt-back etching ayant lieu de façon aléatoire sur la surface de la couche cristalline 130, une réduction de la surface des facettes 132 permet de réduire considérablement voire d'éliminer le risque d'apparition de ce phénomène. On rappellera que le phénomène de melt-back provient de la forte réactivité entre le silicium et le GaN et conduit à une gravure intempestive du silicium par le gallium.

La hauteur e130 de la facette 132, dépend de la profondeur de la rainure 131. Hauteur de facette 132 et profondeur de la rainure 131 sont mesurées perpendiculairement au plan dans lequel s'étendent principalement les différentes couches 110, 120, 130, c'est-à-dire selon la verticale sur les figures 4A à 4G.

Les rainures 131 présentent donc de préférence un fond 121 plat. Ce fond est formé par la face supérieure 121 de la couche d'arrêt 120.

Lorsque la profondeur e130 des rainures 131 est inférieure ou égale à 900 nanomètres, les résultats en termes de diminution du phénomène de melt-back etching sont particulièrement significatifs.

Par ailleurs, en prévoyant la présence de la couche d'arrêt 120 et donc en permettant de réaliser des facettes dont les tailles sont maîtrisées et bien plus homogènes sur la plaque, le procédé permet d'obtenir des couches semi-polaires 162 de nitrure planes et d'épaisseur plus homogène.

De plus, les bains chimiques sont le lieu d'inhomogénéités. L'utilisation de substrats SOI ou, plus généralement, de substrats SOX, permet ainsi d'obtenir des facettes 132 très homogènes en hauteur sur toute la surface du substrat et d'épaisseur contrôlée en dépit des inhomogénéités dues à la gravure chimique. La non uniformité résiduelle est alors celle de l'épaisseur e130 de la couche de silicium du SOI qui n'est que de quelques pourcents comme spécifié par différents fournisseurs de ce type de substrats. Ceci reste vrai pour des substrats de grand diamètre (typiquement 300 mm) et des épaisseurs fines de la couche superficielle de silicium (inférieures à 20 nm).

On notera que la présente invention s'applique également dans le cas où la couche cristalline ne surmonte pas une couche d'arrêt 120 et forme par exemple un substrat massif.

Selon un mode de réalisation, en particulier lorsque la couche cristalline 130 est en silicium et que la couche de nitrure que l'on souhaite faire croître par épitaxie est du GaN, on prévoit de déposer au contact de la couche cristalline 130 de silicium une couche tampon 146 d'AIN. Cela permet de limiter voire d'éviter l'apparition du phénomène de « melt-back etching » qui conduit à une gravure intempestive du silicium par le gallium. Cette couche tampon 146 peut être déposée sur toute la surface supérieure du substrat de croissance 101, comme illustré en figure 4E. Ainsi, dans cet exemple les facettes 132 sont formées par ou sont recouvertes par la couche tampon 146.

Selon un mode de réalisation, une fois les rainures 131 réalisées, et l'éventuelle couche tampon 146 déposée, on forme ensuite un masque 147 configuré pour recouvrir toute la face supérieure du substrat de croissance 101 à l'exception des facettes 132 d'orientation {111}. Ce masque 147 est illustré sur la figure 4E.

Ainsi cette étape de masquage est réalisée de telle sorte que les facettes 133 d'orientation {111} opposées aux facettes 132 présentant une orientation cristalline {111} sont masquées. La réalisation de ce masque 147 comprend typiquement le dépôt d'un matériau comprenant au moins l'un parmi : l'oxyde de silicium (SiO2), le nitrure de silicium (SiN), le nitrure de titane (TiN).

Selon un premier mode de réalisation, illustré en figure 4E, le dépôt de ce masque 147 est un dépôt angulaire exécuté de telle sorte que toute la surface supérieure du substrat cristallin 130 soit masquée, à l'exception desdites facettes 132 qui présentent une orientation cristalline {111}. L'angle d'inclinaison du dépôt fait qu'une partie de la rainure 131, correspondant aux facettes 132, n'est pas exposé et donc ne reçoit donc pas le matériau déposé. Cette étape est accomplie avec l'aide d'un équipement standard connu sous le nom de pulvérisateur par rayonnement ionique ("ion beam sputter" ou IBS) dans lequel l'angle de dépôt peut être ajusté. Ce dépôt avec un angle incliné peut également être obtenu par la technique dite "'Electron beam physical vapor déposition » (EBPVD), signifiant en français dépôt physique en phase gazeuse par faisceau d'électrons, dans laquelle une anode cible sous vide est bombardée par un faisceau d'électrons.

Alternativement à ces techniques permettant un dépôt incliné du matériau formant le masque 147, on peut également prévoir de déposer une couche de masquage d'un matériau comprenant au moins l'un parmi : l'oxyde de silicium (SiO2), le nitrure de silicium (SiN), le nitrure de titane (TiN), puis, suite au dépôt on met à nu les facettes 132 d'orientation {111} afin de les découvrir et permettre le contact entre le nitrure à épitaxier et les facettes 132 d'orientation {111}.

### Croissance de la couche semi-polaire de nitrure

Comme montré sur la figure 4F, les cristallites 161 que l'on fait croître ensuite à partir de ces facettes 132 d'orientation {111} sont alors toutes d'une taille sensiblement égale, à l'incertitude près sur la variation d'épaisseur e130 de la couche cristalline 130, facilitant grandement la coalescence et l'obtention de surfaces semi-polaires planes 162 sur toute l'étendue d'un substrat comme illustré sur la figure 4G.

Dans l'exemple illustré non limitatif en figure 4F on fait croître la couche d'AIN 146 par épitaxie et directement au contact des facettes 132 d'orientation {111} de la couche cristalline 130. Puis on fait ensuite croître, à partir de la couche 146, la couche de nitrure 162, par exemple du GaN.

Les dimensions des facettes 132 d'orientation {111} obtenues à partir de la couche cristalline 130 sont préférentiellement comprises dans une gamme de valeurs allant de 20 nm à 2 µm qui correspond à une gamme d'épaisseurs e130 de la couche cristalline 130 de l'ordre de 10 nm à 1 µm selon l'orientation cristalline de la surface de départ. Les périodes de répétition des bandes 131 du masque 140 sont préférentiellement comprises dans une gamme de valeurs allant de 2 à 10 µm.

Selon un mode de réalisation non illustré, on procède à une étape additionnelle après l'étape d'obtention de la pluralité de rainures parallèles et avant l'étape de croissance épitaxiale de la couche cristalline. Cette étape additionnelle comprend la réalisation d'une pluralité de tranchées parallèles qui s'étendent dans une direction ayant subi une rotation par rapport à direction principale selon laquelle les rainures 360 parallèles s'étendent. Ainsi les rainures 131 sont discontinues.

Selon un mode de réalisation, les tranchées sont tournées, par rapport aux rainures 131, d'un angle qui est supérieur à 40° et qui est de préférence compris entre 50° et 90°, cet angle est mesuré dans un plan parallèle au plan principal dans lequel s'étend le substrat de support 110.

Ainsi, les tranchées interrompent ainsi les rainures 131 continues de manière à former une matrice de facettes individuelles présentant chacune une orientation cristalline {111}. Pendant l'étape de croissance épitaxiale, le matériau croît alors uniquement à partir desdites facettes individuelles qui présentent une orientation cristalline {111} et qui forment ladite matrice. De préférence, les tranchées et les rainures 131 présentant chacune un fond, le fond des tranchées se trouvant à la même profondeur ou en dessous du fond des rainures 131.

La formation des tranchées, inclinées par rapport aux rainures 131, permet de réduire les superficies disponibles des facettes présentant une orientation cristalline {111}. Ce mode de réalisation optionnel mais avantageux permet ainsi une réduction encore plus forte de l'empreinte servant à la croissance épitaxiale et ainsi une réduction des défauts pendant la croissance épitaxiale générée à l'interface GaN/AIN/Si ou AIN/Si tout en imposant la croissance dans la direction +c adéquate.

### Exemple particulier de réalisation

Un exemple particulier de procédé de réalisation d'un substrat de croissance 101 et un exemple particulier de croissance d'une couche semi-polaire 162 de GaN à partir de ce substrat de croissance 101 vont maintenant être détaillés. Cet exemple et d'autres précisions peuvent être retrouvés dans la publication: Rami Mantach et al., J. Appl. Phys. 125, 035703 (2019).

### Réalisation du substrat de croissance 101

La couche de masquage 140 est faite de SiO2. Elle présente une épaisseur de 50 nanomètres. Elle est déposée directement au contact de la couche cristalline 130. Elle est réalisée par pulvérisation par faisceau d'ions (IBS). La couche cristalline 130 est faite de silicium cristallin. Elle présente une épaisseur de 150 nanomètres. La couche d'arrêt 120 est une couche de SiO2. Elle présente une épaisseur de 500 nanomètres. Le substrat de support 110 est en silicium.

Les bandes 141 sont situées le long de la direction [110]. Elles sont définies par photolithographie standard avec une période de 5 µm. Par exemple les bandes 141 présentent une largeur de 2,5 micromètres et les ouvertures entre les bandes 141 présentent également une largeur de 2,5 micromètres.

Le masque 140, fait ici en SiO2, est gravé à l'aide d'un plasma à couplage inductif (ICP). L'échantillon est ensuite nettoyé pendant 30 secondes dans une solution d'oxyde gravant tamponné (BOE) pour éliminer l'oxyde natif, oxyde qui empêche souvent le KOH d'attaquer le silicium. Le substrat est ensuite exposé à une gravure humide à l'aide de KOH, révélant les facettes 132 (111) et 133 (11-1) opposées. Dans cet exemple, ces facettes 132, 133 ont une inclinaison de 48 ° et 60 °, respectivement, par rapport à la surface supérieure de Si (6° off (001) top Si). En utilisant un substrat massif de Si en lieu et place d'un substrat SOI, la gravure se serait arrêtée automatiquement une fois qu'une rainure en forme de V aurait été entièrement formée. Il en aurait résulté deux grandes facettes {111} opposées, de 2 à 3 µm de large. Cela n'aurait pas été optimal pour les raisons indiquées ci-dessus, en termes de densité des défauts ainsi que d'homogénéité et de planéité de la couche de nitrure obtenue. L'utilisation de la couche d'arrêt 120 pour parfaitement contrôler et limiter la surface des facettes 132 permet de limiter, voire de supprimer ces inconvénients.

Une couche tampon 146 d'AIN de 50 nm d'épaisseur est déposée par épitaxie, à 1210°C par MOVPE (épitaxie en phase vapeur aux organométalliques). Les avantages procurés par la présence de cette couche d'AIN pour limiter l'apparition du phénomène de melt-back ecthing ont été évoqués précédemment. Le précurseur de métal utilisé est le triméthylaluminium.

Le deuxième masque 147 est un masque de SiO2. Il est déposé en utilisant un équipement de type IBS et avec un angle d'inclinaison qui permet de laisser à découvert les facettes 132 inclinées à 60 ° en AIN, c'est-à-dire là où la croissance de GaN doit être initiée.

### Formation de la couche semi-polaire 162 de GaN

Avantageusement, le même réacteur MOVPE que celui utilisé précédemment pour le dépôt de la couche tampon 146 d'AIN est utilisé pour la croissance sélective de la couche semi-polaire 162 de GaN. Les précurseurs sont le triméthylgallium (TMGa) et l'ammoniac (NH3).

Le procédé de croissance peut être divisé en deux étapes.

Une première étape comprend la croissance des cristallites 161 ou pyramides GaN. Cette étape s'effectue par exemple à une température de 1090°C. La pression peut être de l'ordre de 300 Torr. Le rapport V / III de débit des gaz injectés dans le réacteur peut être de 1500.

Une deuxième étape vise à réaliser la coalescence des cristallites 161. La croissance se poursuit à la même température mais avec une pression inférieure (100 Torr) et avec un rapport V / III inférieur (650).

On notera que si l'on applique ces mêmes paramètres de croissance en utilisant de grandes facettes 131 de croissance en Si (ce qui sera typiquement le cas avec un substrat massif de Si), cela peut entraîner une croissance parasite. Pour éviter cela, il convient d'ajuster la pression et les débits des gaz TMGa et NH3.

Les paragraphes ci-dessous vont maintenant détailler certains des avantages liés à l'obtention de la couche de nitrure en mettant en oeuvre le procédé décrit précédemment.

Tout d'abord, ce procédé permet d'obtenir une couche semi-polaire. Cela permet de diminuer fortement les effets de polarisation, en particulier l'effet Stark confiné quantique dans les puits quantiques des hétérostructres LEDs, associé au matériau semi-polaire.

En outre, l'épitaxie d'hétérostructures à puits quantiques sur silicium massif structuré et sur SOI structuré, telle que décrite précédemment, permet de faire croître des couches exemptes de contraintes ou soumises à peu de contrainte lors de la coalescence.

Cela permet d'incorporer plus d'indium dans les multi puits quantiques. Il est alors possible d'obtenir des LEDs émettant avec une meilleure qualité dans la gamme de longueur d'onde du vert, et même d'obtenir des LEDs émettant dans la gamme de longueur d'onde du rouge. Des couches tampon d'InGaN semi-polaires, dites métamorphiques, ont par exemple été épitaxiées et sont le lieu de contraintes très réduites voire nulles.

En outre, cela permet de faire des épitaxies plus épaisses sans fissuration. Or, de manière générale, avec les solutions de l'état la technique, l'obtention de couches épitaxiées épaisses entraînent l'apparition de nombreuses fissures voire même souvent la fracturation de la couche obtenue.

Par ailleurs, l'épitaxie d'hétérostructures à puits quantiques, telle que décrite précédemment, permet de générer moins de dislocations ce qui permet une meilleure efficacité radiative des micro-LEDs. Les couches obtenues présentent en effet des densités moyennes de dislocations allant de quelques 10⁶ (pour des techniques de croissance dites Aspect Ratio Trapping) à quelques 10⁷ (sur du SOI standard). Les figures 5A et 5B sont des images en cathodoluminescence d'une couche de GaN dans lesquelles chaque point noir correspond à une dislocation émergente. Les dislocations sont confinées le long de zones 51 formant des lignes correspondant aux zones de coalescence des bandes. Les zones 51 correspondent ainsi aux joints de coalescence. Les zones 52 entre ces lignes de dislocations présentent des densités de dislocations très faibles. La localisation des micro-LEDs dans ces zones 52 à faible voire à zéro défaut est un avantage important dont on peut tirer parti pour en augmenter l'efficacité radiative, notamment pour les grandes longueurs d'ondes. Un exemple d'exploitation judicieuse de ces zones 52 à très faible densité de défauts sera décrite en détail par la suite en référence aux figures 7A et 7B.

Par ailleurs, l'épitaxie d'hétérostructures à puits quantiques, telle que décrite précédemment, permet d'avoir une surface de contact ou d'adhésion entre la structure semi-polaire 160 épitaxiée et le substrat de croissance 101 plus faible. Cette surface de contact est encore plus faible lorsque le substrat de croissance 101 comprend une couche d'arrêt 120 limitant la profondeur des rainures 131 et donc la surface des facettes 132 de croissance. Il est alors possible de régler les conditions pour que l'adhérence de la structure semi-polaire 160 soit suffisante pour permettre une exécution contrôlée du procédé, notamment lors de la croissance épitaxiale, tout en facilitant la séparation de cette structure semi-polaire 160 par rapport à son substrat de croissance 101.

On peut par exemple prévoir que le détachement soit déclenché uniquement par un recuit. Alternativement, on peut prévoir que ce détachement soit favorisé par le recuit. On peut prévoir que ce détachement soit entièrement effectué en partie et de préférence entièrement par l'application d'une contrainte mécanique ou par ultrasons comme cela a été décrit en référence à la figure 2F.

Les figures 5C et 5D sont des images au microscope électronique à balayage d'une coupe d'un assemblage comprenant une structure semi-polaire 160 épitaxiée reposant sur son substrat de croissance 101. Sur la figure 5D qui est un agrandissement de la figure 5C, les zones 51 et 52 sont référencées. Des régions 53, 54, 55 sont également référencées. Ces régions 53, 54, 55 entrent en jeu dans l'adhérence de la structure semi-polaire 160 sur son substrat de croissance 101. La région 53, correspond à la surface des facettes 132 à partir desquelles l'épitaxie est amorcée. La région 54 correspond à un espace « vide » qui ne permet pas la rétention de la structure semi-polaire 160 sur son substrat de croissance 101. La région 55 correspond à la surface de l'interface entre la structure semi-polaire 160 et la face supérieure 121 de la couche d'arrêt 120, typiquement une couche de SiO2. Cette interface participe très peu ou ne participe pas à l'adhérence de la structure semi-polaire 160 sur son substrat de croissance 101. Il apparaît que la surface de la région 53 est très faible au regard des autres régions 54, 55.

Les figures 6A et 6B illustrent de manière schématique l'interface entre la structure semi-polaire 160 et un substrat de croissance 101 de type SOI. Ces figures permettent de mettre en avant des paramètres qui influencent l'adhérence entre la structure semi-polaire 160 et son substrat de croissance 101, et par voie de conséquence la force qu'il faut appliquer pour détacher ces deux ensembles 160, 101.

Si on néglige les forces de cohésion entre les cristallites 161 et la face supérieure 121 de la couche d'arrêt 120 (interface 55 référencée en figure 6A), on peut considérer que la force nécessaire pour entraîner la délamination de la structure semi-polaire 160 par rapport à son substrat 101 dépend du rapport entre la surface de la couche épitaxiée, typiquement la surface de sa deuxième face 164 tournée vers l'extérieur de l'assemblage 100, et la surface développée des facettes 132 (plus précisément, la somme des surfaces S132 des facettes 132) du substrat de croissance 101 servant effectivement à l'épitaxie. En première approximation cela revient à considérer le rapport entre la surface S132 des facettes 132 et la période P1, P2 des rainures 131. Les périodes P1 et P2 sont référencées en figure 6A et 6B respectivement. On peut également considérer le rapport entre la largeur F132 des facettes 132, et la période P1, P2 des rainures 131. La largeur F132 des facettes 132 est référencée en figure 6A et 6B. La largeur F132 est mesurée :
a. dans un plan perpendiculaire au plan principal dans lequel s'étend la face supérieure de la couche cristalline 130 (et la face supérieure 121 de la couche d'arrêt 120 si elle est présente), par exemple le plan de feuille illustrant les figures 6A et 6B,
b. selon la direction d'inclinaison des facettes 132, depuis un sommet 134 des rainures 131 jusqu'à un fond 121 des rainures 131.

Si l'on considère un premier assemblage 101, 160, présentant une période P1, tel qu'illustré en figure 6A, une force F1 est nécessaire pour obtenir un détachement de la structure semi-polaire 160 par rapport son substrat de croissance 101. Si l'on considère un deuxième assemblage, illustré en figure 6B, pour lequel le ratio P/F132 est plus faible, alors il faudra augmenter la force pour obtenir ce détachement. Sur cette figure 6B, la largeur F132 est identique à celle de la figure 6A et la période P2 est inférieure à la période P1. Il faut donc appliquer une force F2 supérieure à la force F1 pour obtenir le détachement. Ainsi, le rapport P1/F132, respectivement P2/F132 contribue significativement au contrôle de la rétention de la structure semi-polaire 160 par rapport à son substrat de croissance 101. Plus ce rapport est élevé plus la rétention est faible et le substrat de croissance 101 peut alors se détacher aisément. Pour faciliter le détachement il faut alors minimiser la surface S132 des facettes 132 et donc leur largeur F132.

Selon un mode de réalisation P/F132≥3. De préférence, P/F132≥5. De préférence, P/F132≥10.

D'autres paramètres permettent de faciliter le décollement des couches semi-polaire sur le substrat de croissance. Ces paramètres peuvent être utilisés séparément ou en combinaison. Ces paramètres sont décrits ci-dessous. Ces paramètres peuvent être mis en oeuvre dans le cadre d'une épitaxie en phase vapeur aux organométalliques (habituellement désignée par l'acronyme, MOVPE provenant du vocable anglais metalorganic vapor phase epitaxy). Néanmoins, d'autres techniques d'épitaxie sont parfaitement envisageables dans le cadre de la présente invention.

Durant l'épitaxie, il faut favoriser la croissance orientée selon la direction « c » (cette direction est référencée en figure 6A), au moins jusqu'à ce que les cristallites 161 entrent en coalescence. A l'inverse, il faut éviter une croissance majoritairement dans les plans semi polaires. Cela permet aux différentes cristallites 161 de se re-joindre rapidement sans trop recouvrir la face 121 de la couche d'arrêt 120. Les paramètres de la croissance épitaxiale peuvent ensuite être modifiés pour privilégier un épaississement de la couche semi-polaire 160 en formation.

Pour cela, lors de la croissance des cristallites 161 on peut travailler à faible pression. Selon un mode de réalisation avantageux, lors de l'épitaxie la pression Pépitaxie est inférieure à 300 Torrs. De préférence Pépitaxie ≤ 200 Torrs. De préférence Pépitaxie ≤ 150 Torrs. De préférence Pépitaxie est égale à 100 Torrs.

De manière alternative ou cumulée à une faible pression, lors de la croissance des cristallites 161 il est préférable également de travailler avec un rapport faible des flux de matériaux V/III. Selon un exemple, ce rapport est inférieur ou égal à 2000. De préférence il est inférieur à 1000, avantageusement de l'ordre de 650.

Selon un exemple, on prévoit que la température Tépitaxie est supérieure à 1050°C, et de préférence Tépitaxie est supérieure à 1100°C. Une température plus élevée permet d'augmenter la mobilité des atomes de Ga déposés en surface, évitant en particulier leur accumulation sur la face supérieure 121 de la couche d'arrêt 120, ce qui autrement pourrait faire adhérer la couche 160 sur la couche d'arrêt 120 et donc rendre son décollement ultérieur plus difficile.

Il est également préférable de considérer le paramètre relatif à la rugosité de la couche d'arrêt 120. Pour cette couche 120, on préférera un matériau lisse, peu rugueux afin de limiter le dépôt sur cette surface et ainsi limiter l'adhérence de la couche épitaxiée sur cette couche d'arrêt 120. De préférence, on choisira ainsi pour la couche d'arrêt 120 un matériau permettant une croissance sélective qui présente un état de surface peu rugueux tel qu'un oxyde. Le SiO2 est un bon candidat. Ainsi, en pratique, la couche d'arrêt est celle qui compose le SOI, donc le plus souvent une couche de SiO2. Sa rugosité est alors celle de l'interface Si/SiO2 thermique ou Si / SiO2 déposé.

Un autre paramètre concerne la largeur (cette largeur « I1 » est référencée en figure 6A) de la zone gravée entre deux mesa formées par la couche cristalline 130 portant les facettes 132. Cette largeur I1 doit être suffisamment importante relativement à la largeur I2 de la mesa (cette largeur « I2 » est référencée en figure 6A). Le rapport e=I2/I1≤20%, de préférence e≤10%.

On peut également utiliser des effets d'ombrage pour éviter la croissance de la facette 132 semi-polaire sous la pyramide. Pour cela on peut par exemple utiliser des méthodes telles que la MBE (Molecular Beam Epitaxy - épitaxie par jet moléculaire) lors de cette phase de croissance. Par exemple, on peut faire de la reprise d'épitaxie en MBE sur des cristallites initialement formées par MOVPE. Dans ce cas, il est préférable que les conditions utilisées lors de la croissance MBE permettent une croissance sélective, c'est-à-dire sans dépôt sur la couche d'arrêt.

Un mode de réalisation particulièrement avantageux va maintenant être décrit en référence aux figures 7A et 7B.

Comme indiqué précédemment dans les paragraphes faisant référence aux figures 5A à 5D, les défauts qui surviennent lors la croissance épitaxiale, en particulier les dislocations au niveau des joints de coalescence des cristallites 161, se concentrent dans des zones 51 étroites. À l'inverse, de larges zones 52 sont exemptes de défauts ou présentent un taux de défauts très faible. Ces zones 51 et 52, illustrés sur les photos des figures 5A et 5B sont également illustrés de manière schématique en figure 7A. Les zones 51 de concentration de défauts, sont réparties de manière périodique dans la couche semi-polaire de nitrure. Cette période P51 est intimement liée à la largeur des bandes 141 du masque dur 140 et la largeur des rainures 131 gravées dans la couche cristalline 130 du substrat de croissance 101.

De manière particulièrement avantageuse, on configure le circuit de contrôle 200 de sorte à ce que les plots 220 de connexion électrique soient fonction de cette période P51, de sorte à ce que la majorité et de préférence que toutes les zones 52 à faible teneur en défauts soient situées au droit d'un seul plot 220 de connexion électrique. Ainsi une même zone 52 à faibles teneurs n'est pas au contact de deux plots 220 de connexion électrique.

Selon un exemple, la période des cristallites 161 et donc la période des zones 51 de concentration des défauts et la répartition des plots 220 de connexion électrique sont adaptées pour y parvenir. De préférence, les plots 220 de connexion électrique, au moins certains d'entre eux et de préférence tous les plots 220, sont répartis de manière périodique sur le circuit de commande 200, selon une période P220.

Selon un exemple non limitatif, P51= X*P220, avec X compris entre 0,8 et 1,2, de préférence X est compris entre 0,9 et 1,1, de préférence X est compris entre 0,95 et 1,05. Cela permet d'avoir une connexion précise de chacune des LEDs 165 aux plots 220 tout en réduisant les contraintes de positionnement de l'assemblage 100 sur le circuit de contrôle 200.

La période P51 comprend de préférence la largeur d'une zone 51 additionnée de la largeur d'une zone 52. Ainsi, P51 représente aussi bien la période de distribution des zones 51 que des zones 52. Les largeurs de ces zones 51, 52 sont de préférence mesurées selon une direction parallèle au plan des première et deuxième faces 163, 164 de la couche épitaxiée et perpendiculaire à la direction principale d'extension des rainures 131 ou bandes 141.

Selon un mode de réalisation optionnel mais particulièrement avantageux, les zones 51 de fortes concentration de dislocations sont situées au droit des régions 230 en matériau isolant 230 séparant les plots 220 adjacents. De manière plus générale, on configure la structure semi-polaire 160 et l'étape d'ouverture des tranchées 170 servant à isoler chaque LED 165, de sorte que les zones 51 soient situées à l'aplomb des tranchées 170. Ainsi, lors de l'étape d'ouverture des tranchées 170, les zones 51 à fortes densité de défauts sont éliminées. Les LEDs 165 sont quant à elles formées dans les zones 52 présentant des densités de défaut faibles ou nulles. La qualité du dispositif optoélectronique en est encore améliorée. Pour mettre en oeuvre ce mode de réalisation on adaptera la distribution, l'emplacement et la taille des zones 51, 52 et des plots 220 de connexion électrique.

Alternativement, et comme cela est représenté en figure 7B, il est possible que certaines zones 51 de concentration des dislocations soient situées au droit d'un plot 220 de connexion électrique.

Selon un exemple, les zones 51 présentent des densités D51 moyennes de dislocations supérieures à au moins K1 fois les densités moyennes D52 de dislocations des zones 52, avec K1>à 10 et de préférence K1>à 100. Selon un exemple les zones 51 sont sensiblement de manière perpendiculaire aux faces principales de la couche semi-polaire 162 de nitrure. De préférence, D51 correspond à une densité minimale observée pour ces zones 51 dans la couche 162 et D52 correspond à une densité maximale observée pour ces zones 52 dans cette même couche 162. Alternativement, D51 correspond à une densité moyenne observée pour ces zones 51 dans la couche 162 et D52 correspond à une densité moyenne observée pour ces zones 52 dans cette même couche 162.

De préférence, pour aligner l'assemblage 100 et le circuit de commande 200 en fonction de leur périodes respectives P51 et P220, on prend comme référence des marques de positionnement portées par le circuit de commande 200.

Au vu de la description qui précède, il apparaît clairement que le procédé proposé offre une solution particulièrement efficace pour obtenir de manière reproductible et peu coûteuse des micro-LEDs aux performances améliorées.

Le procédé proposé s'avère particulièrement intéressant dans le domaine des micros écrans, par exemple pour des applications à la réalité augmentée ou à la réalité mixte, dans le domaine de l'ultra haute définition (UHD), ou encore dans le domaine des projecteurs.

L'invention n'est pas limitée aux modes de réalisations précédemment décrits et s'étend à tous les modes de réalisation couverts par les revendications.

## Revendications

1. Procédé de réalisation d'un dispositif optoélectronique comprenant des micro-diodes électroluminescentes (micro-LEDs) (165) à base de nitrure, le procédé comprenant les étapes suivantes :
a) fournir un assemblage (100) comprenant au moins :
- un substrat de croissance (101) comportant au moins une couche cristalline (130), la couche cristalline (130) comprenant une pluralité de rainures (131) parallèles, chaque rainure (131) comprenant au moins deux facettes inclinées opposées (132, 133) formant chacune une bande continue, au moins l'une (132) desdites deux facettes opposées présentant une orientation cristalline {111} ;
- une structure (160) de nitrure faite au moins en partie d'un nitrure (N) obtenu à partir d'au moins l'un parmi le gallium (Ga), l'indium (In) et l'aluminium (AI), la structure de nitrure (160) comprenant :
∘ une couche semi-polaire (162) de nitrure, présentant une première face (163) tournée au regard de la couche cristalline (130), la couche semi-polaire (162) de nitrure comportant un empilement (1622-1624) comprenant au moins des première (1622) et deuxième (1624) couches semi-conductrices dopées de types de conductivités opposées,
∘ des cristallites (161) s'étendant depuis lesdites facettes (132) présentant une orientation cristalline {111} et jusqu'à la première face (163) de la couche semi-polaire (162) de nitrure,
b) fournir un circuit de contrôle (200) présentant une face avant (212) comportant, ou électriquement connectée à, une pluralité de plots (220) de connexion électrique,
c) rapporter, sur la face avant (212) du circuit de contrôle (200) l'assemblage (100) de sorte que la deuxième couche (1624) de l'empilement (1622-1624) soit électriquement connectée aux plots (220) de connexion électrique du circuit de contrôle (200),
d) retirer le substrat de croissance (101) en séparant les cristallites (161) des facettes (132) présentant une orientation cristalline {111},
e) retirer les cristallites (161),
f) former dans l'empilement (1622-1624) des tranchées (170) de sorte à délimiter une pluralité d'îlots destinés chacun à former une micro-LED (165) et connectés chacun à au moins un plot (220) de connexion électrique du circuit de contrôle (200).

2. Procédé selon la revendication précédente dans lequel, les lesdites facettes (132) présentant une orientation cristalline {111} présentent une largeur F132 et les rainures (131) sont disposées de manière périodique selon une période P, le rapport P/F132 étant tel que P/F132≥3, de préférence, P/F132≥5 et de préférence P/F132≥10, la largeur F132 étant mesurée depuis un sommet (134) des rainures jusqu'à un fond (121) des rainures (131) et selon une direction perpendiculaire à une direction principale d'extension des rainures (131).

3. Procédé selon l'une quelconque des revendications précédentes dans lequel l'étape d) de retrait du substrat de croissance (101) comprend l'application d'une action mécanique sur au moins l'un parmi le substrat de croissance (101) et la structure semi-polaire (160) de nitrure, l'application d'une action mécanique comprenant de préférence un amorçage de fracture depuis un bord de l'un parmi le substrat de croissance (101) et la structure semi-polaire (160) de nitrure à l'aide d'un objet contondant.

4. Procédé selon l'une quelconque des revendications précédentes dans lequel la couche semi-polaire (162) de nitrure comprend une alternance de première zones (51) et de deuxièmes zones (52) formant des bandes ou des lignes parallèles aux rainures (131), les première zones (51) présentant des premières densités de dislocations D51 et les deuxièmes zones (52) présentant des deuxième densités D52 de dislocations, avec D51>K1*D52, avec K1>10, de préférence K1>100.

5. Procédé selon la revendication précédente dans lequel, les deuxièmes zones (52) sont réparties de manière périodique dans la couche semi-polaire (162) de nitrure, par exemple sur une deuxième face (164) opposée à la première face (163), selon une période P51 et les plots (220) de connexion électriques sont distribuées de sorte que la majorité et de préférence que toutes les deuxièmes zones (52) soient respectivement situées au droit d'un seul plot (220) de connexion électrique.

6. Procédé selon l'une quelconque des deux revendications précédentes dans lequel on configure la répartition des premières zones (51) de sorte que les premières zones (51) soient retirées par l'étape f) de formation des tranchées (170).

7. Procédé selon l'une quelconque des trois revendications précédentes dans lequel les plots (220) de connexion électrique sont séparés les uns des autres par des régions (230) électriquement isolantes, les premières zones (51) étant situées au droit des régions (230) électriquement isolantes.

8. Procédé selon l'une quelconque des quatre revendications précédentes dans lequel les plots (220) de connexion électrique sont répartis de manière périodique selon une période P220.

9. Procédé selon la revendication précédente dans lequel les deuxièmes zones (52) sont réparties de manière périodique dans la couche semi-polaire (162) de nitrure, par exemple sur une deuxième face (164) opposée à la première face (163), selon une période P51 et dans lequel P51= X*P220, avec X compris entre 0,8 et 1,2, de préférence X étant compris entre 0,9 et 1,1, de préférence X étant compris entre 0,95 et 1,05.

10. Procédé selon l'une quelconque des revendications précédentes dans lequel l'étape e) de retrait des cristallites (161) comprend une étape de polissage mécanochimique (CMP).

11. Procédé selon l'une quelconque des revendications précédentes, comportant en outre, après l'étape f) de formation des tranchées (170), une étape de dépôt, sur chaque LED (165), d'une électrode (178) sur et en contact avec la première face (163) de la couche semi-polaire (162) de nitrure.

12. Procédé selon l'une quelconque des revendications précédentes dans lequel la fourniture de l'assemblage (100) comprend la fourniture du substrat de croissance (101) et une étape de croissance épitaxiale de la structure semi-polaire (160) de nitrure à partir desdites facettes (132) présentant une orientation cristalline {111}.

13. Procédé selon la revendication précédente dans lequel, le substrat de croissance (101) comprend une couche d'arrêt (120) sur laquelle la couche cristalline (130) repose en étant directement en contact, la couche d'arrêt (120) étant configurée pour permettre la croissance épitaxiale de la structure semi-polaire (160) de nitrure à partir de la couche cristalline (130) sans croissance épitaxiale à partir de la couche d'arrêt (120).

14. Procédé selon l'une quelconque des deux revendications précédentes dans lequel la couche cristalline (130) est à base de silicium ou est faite de silicium et les facettes (132) sont formées par ou sont recouvertes par une couche tampon (146) cristalline, la couche tampon (146) cristalline étant de préférence faite d'AIN.

15. Procédé selon l'une quelconque des trois revendications précédentes dans lequel l'étape de croissance épitaxiale comprend :
a) une première croissance épitaxiale d'un matériau à base de nitrure d'aluminium (AIN) à partir desdites facettes (132) présentant une orientation cristalline {111} ;
b) puis au moins une seconde croissance épitaxiale d'un matériau à base de nitrure de gallium (GaN) à partir dudit matériau à base de nitrure d'aluminium (AIN).

## Patentansprüche

1. Verfahren zur Herstellung einer optoelektronischen Vorrichtung, nitridbasierte elektrolumineszente Mikro-Dioden (Micro-LEDs) (165) umfassend, wobei das Verfahren die folgenden Schritte umfasst:
a) Bereitstellen einer Baugruppe (100), mindestens umfassend:
- ein Wachstumssubstrat (101), mindestens eine kristalline Schicht (130) beinhaltend, wobei die kristalline Schicht (130) eine Vielzahl paralleler Rillen (131) umfasst, wobei jede Rille (131) mindestens zwei gegenüberliegende geneigte Facetten (132, 133) umfasst, die jeweils ein kontinuierliches Band bilden, wobei mindestens eine (132) der zwei gegenüberliegenden Facetten eine Kristallorientierung {111} aufweist;
- eine Nitridstruktur (160), die mindestens teilweise aus einem Nitrid (N) besteht, das ausgehend von mindestens einem unter Gallium (Ga), Indium (In) und Aluminium (Al) erhalten wird, wobei die Nitridstruktur (160) umfasst:
∘ eine semi-polare Nitridschicht (162), die eine erste Fläche (163) aufweist, die der kristallinen Schicht (130) zugewandt ist, wobei die semi-polare Nitridschicht (162) einen Stapel (1622-1624) beinhaltet, der mindestens erste (1622) und zweite (1624) dotierte Halbleiterschichten vom Typ der entgegengesetzten Leitfähigkeit umfasst,
∘ Kristallite (161), die sich von den Facetten (132), die eine Kristallorientierung {111} aufweisen, bis zur ersten Fläche (163) der semi-polaren Nitridschicht (162) erstrecken,
b) Bereitstellen eines Steuerkreises (200), der eine vordere Fläche (212) aufweist, die eine Vielzahl von elektrischen Anschlusspads (220) beinhaltet oder mit diesen elektrisch verbunden ist,
c) Anbringen, auf der vorderen Fläche (212) des Steuerkreises (200), der Baugruppe (100), derart, dass die zweite Schicht (1624) des Stapels (1622-1624) elektrisch mit den elektrischen Anschlusspads (220) des Steuerkreises (200) verbunden ist,
d) Entfernen des Wachstumssubstrats (101) durch Trennen der Kristallite (161) von den Facetten (132), die eine Kristallorientierung {111} aufweisen,
e) Entfernen der Kristallite (161),
f) Bilden von Schneisen (170) im Stapel (1622-1624), derart, dass eine Vielzahl von Inseln abgegrenzt wird, die jeweils dazu bestimmt sind, eine Micro-LED (165) zu bilden, und jeweils mit mindestens einem elektrischen Anschlusspad (220) des Steuerkreises (200) verbunden sind.

2. Verfahren nach dem vorhergehenden Anspruch, wobei die Facetten (132), die eine Kristallorientierung {111} aufweisen, eine Breite F132 aufweisen, und die Rillen (131) periodisch gemäß einer Periode P angeordnet sind, wobei das Verhältnis P/F132 so ist, dass P/F132≥3 ist, vorzugsweise P/F132≥5 und vorzugsweise P/F132≥10, wobei die Breite F132 von einem Scheitelpunkt (134) der Rillen bis zu einem Boden (121) der Rillen (131) gemessen wird, und in einer Richtung senkrecht zu einer Hauptausdehnungsrichtung der Rillen (131).

3. Verfahren nach einem der vorhergehenden Ansprüche, wobei der Schritt d) des Entfernens des Wachstumssubstrats (101) die Anwendung einer mechanischen Maßnahme auf mindestens eines unter dem Wachstumssubstrat (101) und der semi-polaren Nitridstruktur (160) umfasst, wobei die Anwendung einer mechanischen Maßnahme vorzugsweise eine Initiierung des Bruchs von einer Kante unter der des Wachstumssubstrats (101) und der semi-polaren Nitridstruktur (160) ausgehend umfasst, unter Verwendung eines stumpfen Objekts.

4. Verfahren nach einem der vorhergehenden Ansprüche, wobei die semi-polare Nitridschicht (162) eine Alternation der ersten Zonen (51) und der zweiten Zonen (52), die Bänder oder Linien parallel zu den Rillen (131) bilden, umfasst, wobei die ersten Zonen (51) erste Versetzungsdichten D51 aufweisen und die zweiten Zonen (52) zweite Versetzungsdichten D52 aufweisen, wobei D51>K1*D52 ist, wobei K1>10 ist, vorzugsweise K1>100.

5. Verfahren nach dem vorhergehenden Anspruch, wobei die zweiten Zonen (52) periodisch in der semi-polaren Nitridschicht (162) angeordnet sind, beispielsweise auf einer zweiten Fläche (164), die der ersten Fläche (163) gegenüberliegt, gemäß einer Periode P51, und die elektrischen Anschlusspads (220) derart angeordnet sind, dass die Mehrheit der und vorzugsweise alle zweiten Zonen (52) jeweils rechtwinklig zu einem einzelnen elektrischen Anschlusspad (220) liegen.

6. Verfahren nach einem der zwei vorhergehenden Ansprüche, wobei die Verteilung der ersten Zonen (51) derart konfiguriert ist, dass die ersten Zonen (51) durch den Schritt f) der Schneisenbildung (170) entfernt werden.

7. Verfahren nach einem der drei vorhergehenden Ansprüche, wobei die elektrischen Anschlusspads (220) durch elektrisch isolierende Bereiche (230) voneinander getrennt sind, wobei die ersten Zonen (51) rechtwinklig zu den elektrisch isolierenden Bereichen (230) liegen.

8. Verfahren nach einem der vier vorhergehenden Ansprüche, wobei die elektrischen Anschlusspads (220) periodisch gemäß einer Periode P220 verteilt sind.

9. Verfahren nach dem vorhergehenden Anspruch, wobei die zweiten Zonen (52) periodisch in der semi-polaren Nitridschicht (162) verteilt sind, beispielsweise auf einer zweiten Fläche (164), die der ersten Fläche (163) gegenüberliegt, gemäß einer Periode P51, und wobei P51=X*P220 ist, wobei X zwischen 0,8 und 1,2 liegt, X vorzugsweise zwischen 0,9 und 1,1 liegt, X vorzugsweise zwischen 0,95 und 1,05 liegt.

10. Verfahren nach einem der vorhergehenden Ansprüche, wobei der Schritt e) der Entfernung der Kristallite (161) einen mechanochemischen Polierschritt (CMP) umfasst.

11. Verfahren nach einem der vorhergehenden Ansprüche, ferner nach Schritt f) der Schneisenbildung (170) einen Schritt des Abscheidens auf jeder LED (165) einer Elektrode (178) beinhaltend, die auf und in Kontakt mit der ersten Fläche (163) der semi-polaren Nitridschicht (162) ist.

12. Verfahren nach einem der vorhergehenden Ansprüche, wobei das Bereitstellen der Baugruppe (100) die Bereitstellung des Wachstumssubstrats (101) und einen Schritt des epitaktischen Wachstums der semi-polaren Nitridstruktur (160) ausgehend von den Facetten (132), die eine Kristallorientierung {111} aufweisen, umfasst.

13. Verfahren nach dem vorhergehenden Anspruch, wobei das Wachstumssubstrat (101) eine Sperrschicht (120) umfasst, auf der die kristalline Schicht (130) in direktem Kontakt liegt, wobei die Sperrschicht (120) konfiguriert ist, um das epitaktische Wachstum der semi-polaren Nitridstruktur (160) ausgehend von der kristallinen Schicht (130) ohne epitaktisches Wachstum ausgehend von der Sperrschicht (120) zu ermöglichen.

14. Verfahren nach einem der zwei vorhergehenden Ansprüche, wobei die kristalline Schicht (130) siliziumbasierend ist oder aus Silizium besteht, und die Facetten (132) durch eine kristalline Pufferschicht (146) gebildet oder von dieser bedeckt sind, wobei die kristalline Pufferschicht (146) vorzugsweise aus AIN besteht.

15. Verfahren nach einem der drei vorhergehenden Ansprüche, wobei der epitaktische Wachstumsschritt umfasst:
a) ein erstes epitaktisches Wachstum eines Materials auf der Basis von Aluminiumnitrid (AIN) ausgehend von den Facetten (132), die eine Kristallorientierung {111} aufweisen;
b) danach mindestens ein zweites epitaktisches Wachstum eines Materials auf der Basis von Galliumnitrid (GaN) ausgehend vom Material auf der Basis von Aluminiumnitrid (AIN).

## Claims

1. A method for producing an optoelectronic device comprising nitride-based microlight-emitting diodes (micro-LEDs) (165), the method comprising the following steps:
a) providing an assembly (100) comprising at least:
- a growth substrate (101) including at least one crystalline layer (130), the crystalline layer (130) comprising a plurality of parallel grooves (131), each groove (131) comprising at least two opposite inclined facets (132, 133) each forming a continuous strip, at least one (132) of said two opposite facets having a {111} crystal orientation;
- a nitride structure (160) made at least in part of a nitride (N) obtained from at least one of gallium (Ga), indium (In) and aluminium (Al), the nitride structure (160) comprising:
∘ a semi-polar nitride layer (162), having a first face (163) facing the crystalline layer (130), the semi-polar nitride layer (162) including a stack (1622-1624) comprising at least first (1622) and second (1624) doped semiconductor layers of opposite conductivity types,
∘ crystallites (161) extending from said facets (132) having a {111} crystal orientation and up to the first face (163) of the semi-polar nitride layer (162),
b) providing a control circuit (200) having a front face (212) including, or electrically connected to, a plurality of electrical connection pads (220),
c) attaching the assembly (100) to the front face (212) of the control circuit (200) so that the second layer (1624) of the stack (1622-1624) is electrically connected to the electrical connection pads (220) of the control circuit (200),
d) removing the growth substrate (101) by separating the crystallites (161) from the facets (132) having a {111} crystal orientation,
e) removing the crystallites (161),
f) forming in the stack (1622-1624) trenches (170) so as to delimit a plurality of islands each intended to form a micro-LED (165) and each connected to at least one electrical connection pad (220) of the control circuit (200).

2. The method according to the preceding claim, wherein said facets (132) having a {111} crystal orientation have a width F132 and the grooves (131) are disposed periodically according to a period P, the ratio P/F132 being such that P/F132≥3, preferably P/F132≥5 and preferably P/F132≥10, the width F132 being measured from a top (134) of the grooves to a bottom (121) of the grooves (131) and in a direction perpendicular to a main direction of extension of the grooves (131).

3. The method according to any one of the preceding claims, wherein step d) of removing the growth substrate (101) comprises the application of a mechanical action to at least one of the growth substrate (101) and the semi-polar nitride structure (160), the application of a mechanical action preferably comprising fracture initiation from an edge of one of the growth substrate (101) and the semi-polar nitride structure (160) using a blunt object.

4. The method according to any one of the preceding claims, wherein the semi-polar nitride layer (162) comprises alternating first areas (51) and second areas (52) forming strips or lines parallel to the grooves (131), the first areas (51) having first dislocation densities D51 and the second areas (52) having second dislocation densities D52, with D51>K1*D52, with K1>10, preferably K1>100.

5. The method according to the preceding claim, wherein the second areas (52) are distributed periodically in the semi-polar nitride layer (162), for example on a second face (164) opposite the first face (163), according to a period P51 and the electrical connection pads (220) are distributed so that the majority and preferably all of the second areas (52) are respectively located in line with a single electrical connection pad (220).

6. The method according to any one of the two preceding claims, wherein the distribution of the first areas (51) is configured so that the first areas (51) are removed by step f) of forming the trenches (170).

7. The method according to any one of the three preceding claims, wherein the electrical connection pads (220) are separated from each other by electrically insulating regions (230), the first areas (51) being located opposite the electrically insulating regions (230).

8. The method according to any one of the four preceding claims, wherein the electrical connection pads (220) are distributed periodically according to a period P220.

9. The method according to the preceding claim, wherein the second areas (52) are distributed periodically in the semi-polar nitride layer (162), for example on a second face (164) opposite the first face (163), according to a period P51 and wherein P51= X*P220, with X comprised between 0.8 and 1.2, preferably X being comprised between 0.9 and 1.1, preferably X being comprised between 0.95 and 1.05.

10. The method according to any one of the preceding claims, wherein step e) of removing the crystallites (161) comprises a step of chemical-mechanical polishing (CMP).

11. The method according to any one of the preceding claims, further including, after step f) of forming the trenches (170), a step of depositing, on each LED (165), an electrode (178) on and in contact with the first face (163) of the semi-polar nitride layer (162).

12. The method according to any one of the preceding claims wherein providing the assembly (100) comprises providing the growth substrate (101) and a step of epitaxially growing the semi-polar nitride structure (160) from said facets (132) having a {111} crystal orientation.

13. The method according to the preceding claim, wherein the growth substrate (101) comprises a barrier layer (120) on which the crystalline layer (130) lies in direct contact, the barrier layer (120) being configured to allow epitaxial growth of the semi-polar nitride structure (160) from the crystalline layer (130) without epitaxial growth from of the barrier layer (120).

14. The method according to any one of the two preceding claims wherein the crystalline layer (130) is based on silicon or is made of silicon and the facets (132) are formed by or are covered by a crystalline buffer layer (146), the crystalline buffer layer (146) is preferably made of AIN.

15. The method according to any one of the three preceding claims, wherein the epitaxial growth step comprises:
a) a first epitaxial growth of an aluminium nitride (AIN) material from said facets (132) having a {111} crystal orientation;
b) then at least one second epitaxial growth of a material based on gallium nitride (GaN) from said material based on aluminium nitride (AIN).
